# EUROPEAN PATENT APPLICATION

(11) **EP 4 382 967 A1**
(43) Date of publication of application: **12.06.2024**
(21) Application number: 21955433.4
(22) Date of filing: 31.08.2021
(51) Int. Cl.: G01S 17/02

(54) **SIGNAL PROCESSING CIRCUIT, EMISSION SYSTEM, LASER RADAR, AND TERMINAL DEVICE**

(71) Applicant: Huawei Technologies Co., Ltd., Shenzhen, Guangdong 518129 (CN)
(72) Inventor: QIAN, Zhenhai, Shenzhen, Guangdong 518129 (CN); CAI, Zhonghua, Shenzhen, Guangdong 518129 (CN); GAO, Lei, Shenzhen, Guangdong 518129 (CN); ZHANG, Huahong, Shenzhen, Guangdong 518129 (CN)
(74) Representative: Isarpatent
(86) International application number: PCT/CN2021/115795
(87) International publication number: WO 2023/028878

(57) **Abstract**

A signal processing circuit, a transmitting system, a lidar, and a terminal device are provided, applicable to the field of electronic technologies, used to limit a width of a valid level of an output control signal, and used for autonomous driving or assisted driving. The signal processing circuit includes a first subcircuit. Two input terminals of the first subcircuit respectively receive a first control signal and a second control signal. The first subcircuit is configured to: perform a logical operation, and output a third control signal at an output terminal of the first subcircuit. A width of a valid level of the third control signal is not greater than a width of a valid level of the first control signal. In this way, even if a previous-stage circuit of the signal processing circuit outputs the first control signal whose valid level has a larger width, the third control signal whose valid level has a smaller width can be output, to effectively protect a next-stage circuit. The method may be applied to the internet of vehicles, for example, vehicle-to-everything V2X, long term evolution-vehicle LTE-V, or vehicle-to-vehicle V2V.

## Description

### TECHNICAL FIELD

This application relates to the field of electronic technologies, and provides a signal processing circuit, a transmitting system, a lidar, and a terminal device.

### BACKGROUND

With increasing requirements for laser application, increasingly high requirements are imposed on lasers in the industry. Currently, mainstream lasers are usually designed with high power. High-power lasers have larger drive currents, higher laser intensity, longer detection distances, and higher detection precision, and are currently widely used in the fields such as industrial processing and biomedicine.

However, the high-power laser requires that duration of a control signal cannot be excessively long. Experiments show that a drive current of a high-power single-channel laser can reach tens of amperes, and a drive current of a high-power multi-channel laser can reach hundreds of amperes or even thousands of amperes. Under such a high drive current, if the duration of the control signal is excessively long, the laser works at ultra-high power for a long time. As a result, the laser heats up obviously, and the laser may even be burnt in a serious situation. Therefore, how to effectively limit the duration of the control signal is crucial to maintaining a service life of the laser.

### SUMMARY

This application provides a signal processing circuit, a transmitting system, a lidar, and a terminal device, to limit duration of a valid level of a control signal.

According to a first aspect, this application provides a signal processing circuit, including a first subcircuit. The first subcircuit includes a first input terminal, a second input terminal, and an output terminal. The first input terminal of the first subcircuit is configured to receive a first control signal, the second input terminal of the first subcircuit is configured to receive a second control signal, and the first subcircuit is configured to: perform a logical operation on the first control signal and the second control signal, and output a third control signal at the output terminal of the first subcircuit. A width of a valid level of the third control signal is not greater than a width of a valid level of the first control signal. A valid level is a level that can trigger a next-stage circuit to work (for example, trigger a laser to emit light), and is used to describe an amplitude of a voltage. For example, being valid at a low level means that the next-stage circuit is triggered to work when the voltage is less than a voltage threshold, and the next-stage circuit does not work when the voltage is greater than or equal to the voltage threshold. Being valid at a high level means that the next-stage circuit is triggered to work when the voltage is greater than or equal to the voltage threshold, and the next-stage circuit does not work when the voltage is less than the voltage threshold. A width is described from a time dimension, and a width of a valid level is duration of the valid level.

In the foregoing design, even if a status of a previous-stage circuit of the signal processing circuit is unstable, and consequently, duration of the valid level of the first control signal is longer, the first subcircuit can output the third control signal having a narrow valid level, that is, duration of the valid level of the third control signal is shorter. In this way, under an action of the third control signal, the next-stage circuit (for example, the laser) can work in short duration, and a next-stage circuit is effectively protected by limiting working duration of the next-stage circuit. Further, in comparison with a feedback adjustment manner, after receiving the first control signal, the first subcircuit can directly output the third control signal with a narrow level width, without referring to a drive current or transmit power on the next-stage circuit. Therefore, a delay of collecting information and reporting information can be further reduced, and real-time performance of signal processing can be improved. In addition, the first subcircuit belongs to a logical operation circuit, and the logical operation circuit has a simple circuit structure. This helps reduce circuit complexity and further reduce circuit costs.

In a possible design, when the width of the valid level of the first control signal is not greater than a threshold width, the width of the valid level of the third control signal is the same as the width of the valid level of the first control signal. The threshold width is described from a time dimension, and indicates threshold duration that affects the next-stage circuit. When the working duration of the next-stage circuit is less than or equal to the threshold width, it means that the next-stage circuit is not affected, that is, the next-stage circuit can still work normally. When the working duration of the next-stage circuit is greater than the threshold width, it means that the next-stage circuit is affected. For example, because the next-stage circuit is in a working state for a long time, a risk of burning out the next-stage circuit increases. In this design, when the width of the valid level of the first control signal does not exceed the threshold width that affects the next-stage circuit, the width of the valid level of the third control signal changes in real time with the width of the first control signal, so that the signal processing circuit is compatible with some scenarios in which the width needs to be dynamically adjusted.

In a possible design, when the width of the valid level of the first control signal is greater than a threshold width, the width of the valid level of the third control signal is less than the width of the valid level of the first control signal. In this way, when the width of the valid level of the first control signal exceeds the threshold width that affects the next-stage circuit, a protection mechanism can be provided for the next-stage circuit by limiting the width of the valid level of the third control signal, and the previous-stage circuit of the signal processing circuit does not need to necessarily output the first control signal having a narrow width. This can further reduce a requirement for real-time performance of transmission of a control signal that needs to be transmitted at a high speed.

In a possible design, when the signal processing circuit is used in a lidar, the threshold width may be preset or configured as a time parameter in 0 ns to 100 ns, and may be preferably set to a time parameter in 0 ns to 10 ns, to design, based on an actual requirement, longest transmission duration for a transmitting circuit in the lidar to send a laser signal, so as to protect safety of the transmitting circuit. In addition, transmission duration of the laser signal is limited, to prevent the laser signal from being exposed to a human eye for a long time, and protect safety of the human eye.

In a possible design, within a width of one valid level of the first control signal, a width of a first level of the second control signal may be a smallest width in the width of the valid level and the threshold width. In this way, after receiving the first control signal and the second control signal, the first subcircuit determines, in an overlapping width of the valid level of the first control signal and the first level of the second control signal, that the level of the third control signal obtained through the logical operation is a valid level, and determines, in a non-overlapping width of the valid level of the first control signal and the first level of the second control signal, that the level of the third control signal obtained through the logical operation is an invalid level. The first level of the second control signal may be the valid level of the first control signal, or may be an invalid level of the first control signal, or may be a level range, where a level difference between the level range and the valid level of the first control signal is less than a value or a level difference between the level range and the valid level of the first control signal is greater than a value, or the like. This is not specifically limited. In this way, in this design, a width relationship between the second control signal and the first control signal can be designed, to obtain the third control signal, where the width of the valid level of the third control signal does not exceed the smallest width in the width of the valid level of the first control signal and the threshold width.

In a possible design, the first control signal and the second control signal may be from a same control circuit, so that the control circuit can further flexibly adjust, based on an actual requirement corresponding to the first control signal, the second control signal used for the logical operation, to improve flexibility of generating the third control signal.

In a possible design, the signal processing circuit may further include a second subcircuit. The second subcircuit includes an input terminal and an output terminal. The input terminal of the second subcircuit is configured to receive the first control signal, and the output terminal of the second subcircuit is connected to the second input terminal of the first subcircuit. The second subcircuit may perform phase adjustment on the first control signal, and output the second control signal at the output terminal of the second subcircuit. Phase adjustment means to adjust a time sequence of a signal. A pulse signal is used as an example. Delaying arrival time of a pulse in the pulse signal, or making a pulse in the pulse signal arrive in advance for a period of time, or changing duration of a pulse in the pulse signal all fall within a scope of phase adjustment. In this way, because the second control signal is obtained by adjusting a phase of the first control signal, the second control signal can further change in real time with a change of the currently actually received first control signal, so that the second control signal can better match the first control signal in a current scenario, to improve accuracy of determining the third control signal. In addition, the second subcircuit is a phase adjustment circuit, and the phase adjustment circuit has a simple circuit structure and circuit logic that is easy to implement. This helps further reduce circuit complexity and further reduce circuit costs.

In a possible design, the signal processing circuit may further include N second subcircuits that have different phase adjustment amplitudes and N switches, the N switches are in a one-to-one correspondence with the N second subcircuits, and N is a positive integer greater than or equal to 2. The N switches may be further connected to the control circuit. In this way, when a phase adjustment amplitude of the second control signal relative to the first control signal needs to be adjusted, the N switches can further receive a control signal sent by the control circuit. A target switch is turned on based on the control signal, to connect a transmission link between a target second subcircuit corresponding to the target switch and the first subcircuit. N-1 switches other than the target switch are turned off, to disconnect a transmission link between the first subcircuit and the N-1 second subcircuits other than the target second subcircuit, to perform phase adjustment on the first control signal by using a phase adjustment amplitude corresponding to the target second subcircuit, so as to obtain the second control signal with a required phase, and flexibly adjust the width of the valid level of the third control signal.

In a possible design, the second subcircuit includes a resistor-capacitor (resistor capacitance, RC) circuit, which is also referred to as an RC delay circuit. The RC delay circuit can not only delay the phase of the first control signal (that is, delay arrival time of a pulse in the first control signal) to obtain the second control signal, but also implement delay by using a simple resistor element and a capacitor element. A circuit structure is simple and easy to implement. The following describes several possible circuit structures of the signal processing circuit implemented by using the RC delay circuit.

Solution 1: The second subcircuit includes a resistor, a capacitor, and a phase inverter, a first terminal of the resistor is the input terminal of the second subcircuit, a second terminal of the resistor is connected to both a first terminal of the capacitor and an input terminal of the phase inverter, a second terminal of the capacitor is grounded, and an output terminal of the phase inverter is the output terminal of the second subcircuit.

In an example of Solution 1, the valid level of the first control signal is a high level, and the first subcircuit may include an AND operation circuit. A first input terminal of the AND operation circuit is the first input terminal of the first subcircuit, a second input terminal of the AND operation circuit is the second input terminal of the first subcircuit, and an output terminal of the AND operation circuit is the output terminal of the first subcircuit.

In another example of Solution 1, the valid level is a high level, and the first subcircuit may include a NAND operation circuit and a level inversion circuit. A first input terminal of the NAND operation circuit is the first input terminal of the first subcircuit, a second input terminal of the NAND operation circuit is the second input terminal of the first subcircuit, an output terminal of the NAND operation circuit is connected to an input terminal of the level inversion circuit, and an output terminal of the level inversion circuit is the output terminal of the first subcircuit.

In still another example of Solution 1, the valid level of the first control signal is a low level, and the first subcircuit may include a NOR operation circuit. A first input terminal of the NOR operation circuit is the first input terminal of the first subcircuit, a second input terminal of the NOR operation circuit is the second input terminal of the first subcircuit, and an output terminal of the NOR operation circuit is the output terminal of the first subcircuit.

In yet another example of Solution 1, the valid level of the first control signal is a low level, and the first subcircuit may include an OR operation circuit and a level inversion circuit. A first input terminal of the OR operation circuit is the first input terminal of the first subcircuit, a second input terminal of the OR operation circuit is the second input terminal of the first subcircuit, an output terminal of the OR operation circuit is connected to an input terminal of the level inversion circuit, and an output terminal of the level inversion circuit is the output terminal of the first subcircuit.

In still another example of Solution 1, the valid level of the first control signal is a low level or a high level, and the first subcircuit may include an XOR operation circuit and a level inversion circuit. A first input terminal of the XOR operation circuit is the first input terminal of the first subcircuit, a second input terminal of the XOR operation circuit is the second input terminal of the first subcircuit, an output terminal of the XOR operation circuit is connected to an input terminal of the level inversion circuit, and an output terminal of the level inversion circuit is the output terminal of the first subcircuit.

In yet another example of solution 1, the valid level of the first control signal is a low level or a high level, and the first subcircuit may include an XNOR operation circuit. A first input terminal of the XNOR operation circuit is the first input terminal of the first subcircuit, a second input terminal of the XNOR operation circuit is the second input terminal of the first subcircuit, and an output terminal of the XNOR operation circuit is the output terminal of the first subcircuit.

Solution 2: The second subcircuit includes a resistor and a capacitor, a first terminal of the resistor is the input terminal of the second subcircuit, a second terminal of the resistor is used as the output terminal of the second subcircuit after being connected to a first terminal of the capacitor, and a second terminal of the capacitor is grounded.

In an example of Solution 2, the valid level of the first control signal is a low level, and the first subcircuit may include a phase inverter and an AND operation circuit. An input terminal of the phase inverter is the first input terminal of the first subcircuit, an output terminal of the phase inverter is connected to a first input terminal of the AND operation circuit, a second input terminal of the AND operation circuit is the second input terminal of the first subcircuit, and an output terminal of the AND operation circuit is the output terminal of the first subcircuit.

In another example of Solution 2, the valid level of the first control signal is a low level, the first subcircuit may include a phase inverter, a NAND operation circuit, and a level inversion circuit. An input terminal of the phase inverter is the first input terminal of the first subcircuit, an output terminal of the phase inverter is connected to a first input terminal of the NAND operation circuit, a second input terminal of the NAND operation circuit is the second input terminal of the first subcircuit, an output terminal of the NAND operation circuit is connected to an input terminal of the level inversion circuit, and an output terminal of the level inversion circuit is the output terminal of the first subcircuit.

In still another example of Solution 2, a valid level of the first control signal is a high level, and the first subcircuit may include a phase inverter and a NOR operation circuit. An input terminal of the phase inverter is the first input terminal of the first subcircuit, an output terminal of the phase inverter is connected to a first input terminal of the NOR operation circuit, a second input terminal of the NOR operation circuit is the second input terminal of the first subcircuit, and an output terminal of the NOR operation circuit is the output terminal of the first subcircuit.

In yet another example of Solution 2, the valid level of the first control signal is a high level, and the first subcircuit may include a phase inverter, an OR operation circuit, and a level inversion circuit. An input terminal of the phase inverter is the first input terminal of the first subcircuit, an output terminal of the phase inverter is connected to a first input terminal of the OR operation circuit, a second input terminal of the OR operation circuit is the second input terminal of the first subcircuit, an output terminal of the OR operation circuit is connected to an input terminal of the level inversion circuit, and an output terminal of the level inversion circuit is the output terminal of the first subcircuit.

In still another example of Solution 2, the valid level of the first control signal is a high level or a low level, and the first subcircuit may include a phase inverter, an XOR operation circuit, and a level inversion circuit. An input terminal of the phase inverter is the first input terminal of the first subcircuit, an output terminal of the phase inverter is connected to a first input terminal of the XOR operation circuit, a second input terminal of the XOR operation circuit is the second input terminal of the first subcircuit, an output terminal of the XOR operation circuit is connected to an input terminal of the level inversion circuit, and an output terminal of the level inversion circuit is the output terminal of the first subcircuit.

In still another example of Solution 2, the valid level of the first control signal is a high level or a low level, and the first subcircuit may include a phase inverter and an XNOR operation circuit. An input terminal of the phase inverter is the first input terminal of the first subcircuit, an output terminal of the phase inverter is connected to a first input terminal of the XNOR operation circuit, a second input terminal of the XNOR operation circuit is the second input terminal of the first subcircuit, and an output terminal of the XNOR operation circuit is the output terminal of the first subcircuit.

In still another example of Solution 2, the valid level of the first control signal is a high level or a low level, and the first subcircuit may include an XNOR operation circuit and a level inversion circuit. A first input terminal of the XNOR operation circuit is the first input terminal of the first subcircuit, a second input terminal of the XNOR operation circuit is the second input terminal of the first subcircuit, an output terminal of the XNOR operation circuit is connected to an input terminal of the level inversion circuit, and an output terminal of the level inversion circuit is the output terminal of the first subcircuit.

In yet another example of Solution 2, a valid level of the first control signal is a high level or a low level, and the first subcircuit may include an XOR operation circuit. A first input terminal of the XOR operation circuit is the first input terminal of the first subcircuit, a second input terminal of the XOR operation circuit is the second input terminal of the first subcircuit, and an output terminal of the XOR operation circuit is the output terminal of the first subcircuit.

In a possible design, for any example of the foregoing Solution 1 or Solution 2, the level inversion circuit may include a P-channel metal-oxide-semiconductor field-effect transistor (P-channel metal-oxide-semiconductor field-effect transistor, PMOS) and an N-channel metal-oxide-semiconductor field-effect transistor (N-channel metal-oxide-semiconductor field-effect transistor, NMOS). A gate of the PMOS is connected to a gate of the NMOS and then used as the input terminal of the level inversion circuit, a drain of the PMOS is connected to a drain of the NMOS and then used as the output terminal of the level inversion circuit, a source of the PMOS is connected to a drive power supply, and a source of the NMOS is grounded. In this way, the level inversion circuit can not only invert an input low level to a high level for output, but also convert an input high level to a low level for output, and can further implement a power driving function for the next-stage circuit. In some scenarios, the level inversion circuit is also referred to as a power drive circuit.

In a possible design, when the signal processing circuit includes N second subcircuits, if each second subcircuit includes the resistor-capacitor circuit in the foregoing Solution 1 or Solution 2, time constants of the resistor-capacitor circuits of the N second subcircuits are different. The different time constants may be implemented by using different resistance values of resistors and/or different capacitance values of capacitors. In this way, time constants of resistor-capacitor circuits corresponding to different second subcircuits are different, that is, different second subcircuits can have different delay capabilities. This helps flexibly obtain the phase adjustment amplitude used by the second control signal.

In a possible design, when the second subcircuit includes a phase inverter, the phase inverter may further increase or decrease a decision threshold based on a threshold adjustment message from the control circuit. In this way, when the decision threshold is increased, the second control signal delayed by the RC delay circuit less likely reaches the decision threshold. This helps to provide the third control signal with a large width as much as possible when a requirement is met. When the decision threshold is decreased, the second control signal delayed by the RC delay circuit more likely reaches the decision threshold. This helps to shorten the width of the valid level of the third control signal and protect the next-stage circuit more securely.

According to a second aspect, this application provides a transmitting system, including a transmitting circuit and the signal processing circuit according to any design of the first aspect. An output terminal of the signal processing circuit is connected to the transmitting circuit. The signal processing circuit may send a determined third control signal to the transmitting circuit, and the transmitting circuit may send a laser signal based on the third control signal output by the signal processing circuit.

According to a third aspect, this application provides a lidar, including a control circuit and the transmitting system according to the second aspect. The control circuit may input a first control signal to the transmitting system, so that a signal processing circuit in the transmitting system generates a third control signal with a small width based on the first control signal, and then sends the third control signal to the transmitting circuit.

According to a fourth aspect, this application provides a terminal device, including the lidar according to the third aspect. For example, examples of some terminal devices include but are not limited to a smart home device (for example, a television, a floor sweeping robot, a smart desk lamp, an acoustic system, a smart lighting system, an electrical appliance control system, home background music, a home theater system, an intercom system, or a video monitor), an intelligent transportation device (for example, a car, a ship, an uncrewed aerial vehicle, a train, a van, or a truck), a smart manufacturing device (for example, a robot, an industrial device, intelligent logistics, or a smart factory), and a smart terminal (a mobile phone, a computer, a tablet computer, a palmtop computer, a desktop computer, a headset, a speaker, a wearable device, a vehicle-mounted device, a virtual reality device, an augmented reality device, or the like).

For beneficial effect of the second aspect to the fourth aspect, refer to technical effect that can be achieved by corresponding designs in the first aspect. Details are not described herein again.

### BRIEF DESCRIPTION OF DRAWINGS

FIG. 1 is a schematic diagram of an example of an application scenario of a lidar according to an embodiment of this application;
FIG. 2 is a schematic diagram of an internal architecture of a lidar according to an embodiment of this application;
FIG. 3 is a schematic diagram of an example of a structure of a signal processing circuit according to an embodiment of this application;
FIG. 4 is a diagram of an example of an association relationship between a second control signal and a first control signal according to an embodiment of this application;
FIG. 5 is a schematic diagram of an example of a connection relationship according to an embodiment of this application;
FIG. 6 is a schematic diagram of an example of a structure of another signal processing circuit according to an embodiment of this application;
FIG. 7 is a schematic diagram of an example of a structure of still another signal processing circuit according to an embodiment of this application;
FIG. 8 is a schematic diagram of an example of a structure of a level inversion circuit according to an embodiment of this application;
FIG. 9 is a schematic diagram of an example of a structure of a signal processing circuit according to Embodiment 1 of this application;
FIG. 10 is a schematic diagram of an example of a time sequence of a control signal in a signal processing circuit according to Embodiment 1 of this application;
FIG. 11 is a schematic diagram of an example of a structure of another signal processing circuit according to Embodiment 1 of this application;
FIG. 12 is a schematic diagram of an example of a structure of still another signal processing circuit according to Embodiment 1 of this application;
FIG. 13 is a schematic diagram of an example of a structure of yet another signal processing circuit according to Embodiment 1 of this application;
FIG. 14 is a schematic diagram of an example of a time sequence of another control signal in a signal processing circuit according to Embodiment 1 of this application;
FIG. 15 is a schematic diagram of an example of a structure of still another signal processing circuit according to Embodiment 1 of this application;
FIG. 16 is a schematic diagram of an example of a structure of still another signal processing circuit according to Embodiment 1 of this application;
FIG. 17 is a schematic diagram of an example of a time sequence of still another control signal in a signal processing circuit according to Embodiment 1 of this application;
FIG. 18 is a schematic diagram of an example of a structure of yet another signal processing circuit according to Embodiment 1 of this application;
FIG. 19 is a schematic diagram of an example of a structure of a signal processing circuit according to Embodiment 2 of this application;
FIG. 20 is a schematic diagram of an example of a time sequence of a control signal in a signal processing circuit according to Embodiment 2 of this application;
FIG. 21 is a schematic diagram of an example of a structure of another signal processing circuit according to Embodiment 2 of this application;
FIG. 22 is a schematic diagram of an example of a structure of still another signal processing circuit according to Embodiment 2 of this application;
FIG. 23 is a schematic diagram of an example of a time sequence of another control signal in a signal processing circuit according to Embodiment 2 of this application;
FIG. 24 is a schematic diagram of an example of a structure of yet another signal processing circuit according to Embodiment 2 of this application;
FIG. 25 is a schematic diagram of an example of a structure of still another signal processing circuit according to Embodiment 2 of this application;
FIG. 26 is a schematic diagram of an example of a time sequence of still another control signal in a signal processing circuit according to Embodiment 2 of this application;
FIG. 27 is a schematic diagram of an example of a structure of yet another signal processing circuit according to Embodiment 2 of this application;
FIG. 28 is a schematic diagram of an example of a structure of still another signal processing circuit according to Embodiment 2 of this application;
FIG. 29 is a schematic diagram of an example of a time sequence of yet another control signal in a signal processing circuit according to Embodiment 2 of this application; and
FIG. 30 is a schematic diagram of an example of a structure of yet another signal processing circuit according to Embodiment 2 of this application.

### DESCRIPTION OF EMBODIMENTS

A signal processing circuit disclosed in embodiments of this application may be used in a terminal device having a signal processing capability, and in particular, is applicable to a terminal device having a capability of processing a control signal of a laser. In some embodiments of this application, the signal processing circuit may be a terminal device or an independent unit. When the signal processing circuit is an independent unit, the unit may be embedded in a terminal device, and can output a control signal with a short-duration valid level to a next-stage circuit of the signal processing circuit when a previous-stage circuit of the signal processing circuit in the terminal device outputs a control signal with a long-duration valid level, to protect safety of the next-stage circuit. The terminal device may be an intelligent device having a control signal processing capability, including but not limited to: a smart home device, for example, a television, a floor sweeping robot, a smart desk lamp, an acoustic system, a smart lighting system, an electrical appliance control system, home background music, a home theater system, an intercom system, or a video surveillance system; an intelligent transportation device, for example, a vehicle, a ship, an uncrewed aerial vehicle, or a truck; and a smart manufacturing device, for example, a robot or an industrial device. Alternatively, the terminal device may be a computer device having a control signal processing capability, for example, a desktop computer or a personal computer. It should be further understood that the terminal device may alternatively be a portable electronic device having a control signal processing capability, for example, a mobile phone, a tablet computer, a palmtop computer, a headset, an acoustic device, a wearable device (for example, a smartwatch), a vehicle-mounted device, a virtual reality device, or an augmented reality device.

The following clearly and completely describes the technical solutions in embodiments of this application with reference to the accompanying drawings in embodiments of this application. It should be understood that in the following descriptions of embodiments of this application, "a plurality of" may be understood as "at least two". "And/or" describes an association relationship between associated objects, and represents that three relationships may exist. For example, A and/or B may represent the following cases: Only A exists, both A and B exist, and only B exists, where A and B may be singular or plural. Words such as "first", "second", and "third" are merely used for distinction and description, and shall not be understood as an indication or implication of relative importance or an indication or implication of an order. For example, the "first control signal", "second control signal", and "third control signal" mentioned below are merely used to indicate different control signals, and do not have different sequences, priorities, or importance degrees.

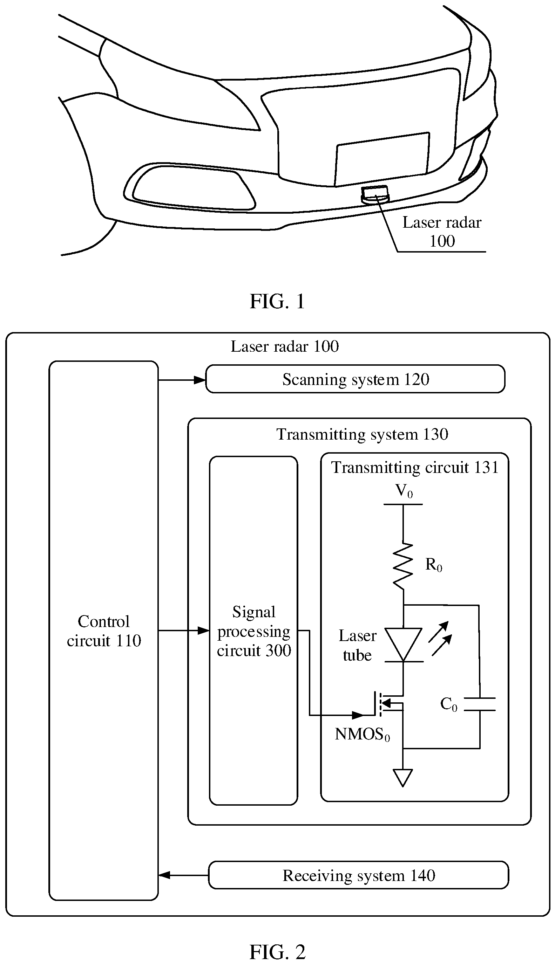

In a specific application scenario, the signal processing circuit may be used in a lidar (lidar, LR). FIG. 1 is a schematic diagram of an example of an application scenario of a lidar according to an embodiment of this application. In this example, a lidar 100 is installed on a vehicle, and therefore is also referred to as a vehicle-mounted lidar. In addition to the vehicle-mounted lidar, the lidar also includes a ship-mounted lidar installed on a ship, or an airborne lidar installed on a machine. In a possible example, as shown in FIG. 1, the lidar 100, for example, may be installed at a vehicle head location of the vehicle. In this way, in a driving process of the vehicle, the lidar 100 may send a laser signal. The laser signal is reflected by an object in an ambient environment after being irradiated to the object, and a reflected target echo signal may be received by the lidar 100. Then, the lidar 100 obtains environment information around the vehicle through detection based on the target echo signal, to use the environment information to assist or control a driving function of the vehicle, for example, including but not limited to autonomous driving or assisted driving.

It should be noted that the lidar 100 may be one of a mechanical lidar, a liquid lidar, a pure solid-state lidar, or a hybrid solid-state lidar (also referred to as a semi-solid-state lidar), or may be another type of lidar. This is not specifically limited in embodiments of this application. In addition, a housing of the lidar 100 may be a cuboid shown in FIG. 1, or may be a square, a cylinder, an annular body, an amorphous body, or the like. This is not specifically limited in embodiments of this application.

Further, for example, FIG. 2 is a schematic diagram of an internal architecture of a lidar according to an embodiment of this application. As shown in FIG. 2, the lidar 100 may include a control circuit 110, a scanning system 120, a transmitting system 130, and a receiving system 140. The transmitting system 130 and the receiving system 140 include an optical element, for example, one or more of a lens, a light filter, a polarizer, a reflection mirror, a beam splitting mirror, a prism, a window plate, and a scattering sheet. A specific quantity of included optical elements and a specific type of the included optical element are related to optical designs of the transmitting system and the receiving system of the lidar. This is not specifically limited in embodiments of this application. The transmitting system 130 further includes a transmitting circuit 131. At least one laser (namely, a laser tube) is disposed in the transmitting circuit 131, and the at least one laser is configured to send a laser signal. The scanning system 120 may include one or more of a polygon mirror, an oscillating mirror, a micro-electro-mechanical (micro-electro-mechanical system, MEMS) scanning mirror, or a prism, and is configured to change a scanning angle of the laser signal, so that a laser signal transmitted by the transmitting system 130 scans and traverses objects in an environment. The laser signal is further reflected by an object in the environment to generate a target echo signal, and the receiving system 140 is configured to receive the target echo signal corresponding to the laser signal. The receiving system 140 and the transmitting system 130 may be coaxial, or may be heteroaxial. Alternatively, one transmitting system 130 may correspond to one receiving system 140, or one transmitting system 130 may correspond to a plurality of receiving systems 140, or a plurality of transmitting systems 130 may correspond to one receiving system 140, or a plurality of transmitting systems 130 may correspond to a plurality of receiving systems 140. This is not specifically limited. It should be noted that the lidar 100 may alternatively include more or fewer components than those shown in FIG. 2. This is not specifically limited in embodiments of this application.

The control circuit 110 may be an integrated circuit chip, and has a signal processing capability. For example, the control circuit 110 may be a general-purpose processor, may be a field programmable gate array (field programmable gate array, FPGA), may be a an application-specific integrated chip (application-specific integrated circuit, ASIC), may be a system on chip (system on chip, SoC), may be a network processor (network processor, NP), may be a digital signal processing circuit (digital signal processor, DSP), may be a micro controller (micro controller unit, MCU), may be a programmable logic device (programmable logic device, PLD), or may be another programmable logic device, discrete gate or transistor logic device, discrete hardware component, or another integrated chip. The control circuit 110 may include an element or a circuit having a processing capability, for example, may include a central processing unit (central processor unit, CPU), a neural-network processing unit (neural-network processing unit, NPU), or a graphics processing unit (graphics processing unit, GPU), for another example, may include an application processor (application processor, AP), a modem processor, an image signal processor (image signal processor, ISP), a video codec, a digital signal processor (digital signal processor, DSP), and/or a baseband processor. This is not specifically limited.

The control circuit 110 may further be connected to another component in the lidar 100. In a driving process of the vehicle, the control circuit 110 may determine a scanning manner of an ambient environment based on a preset configuration or a command indicated by a user, and send a scanning control signal to the scanning system 120 in the scanning manner. The scanning manner includes but is not limited to a scanning angle, a scanning dimension (one-dimensional scanning, two-dimensional scanning, three-dimensional scanning, or the like), a scanning periodicity, or the like. In addition, the control circuit 110 may further determine a transmission manner of a laser signal, and send a transmission control signal to the transmitting circuit 131 in the transmitting system 130 in the transmission manner. The transmission manner includes but is not limited to a transmission duration, a transmission periodicity, transmission strength, or the like. Further, the transmitting circuit 131 sends a laser signal under an action the transmission control signal. After a target object in the environment is found through scanning by using the scanning system 120, the laser signal is reflected by the target object. A reflected target echo signal may be received by the receiving system 140, and sent by the receiving system 140 to the control circuit 110. The control circuit 110 may obtain related information of the target object by comparing the received target echo signal with the transmitted laser signal (for example, comparing a time difference between receiving and transmitting with a signal strength difference between receiving and sending), for example, a distance, an orientation, a height, a speed, a posture, and even a shape. The related information may be further used subsequently to plan autonomous driving or assisted driving of the vehicle with reference to other sensor information of the vehicle.

However, for the control signal sent by the control circuit 110, a valid signal may last for a long time. In this case, the valid signal that lasts for a long time also drives the laser inside the transmitting circuit 131 to send the laser signal for a long time. This is not only unfavorable to safety of the laser and even the transmitting circuit 131, but also may damage human eyes due to long-time laser signal illumination. Currently, for the foregoing problem, the following solution exists: collecting a real drive current and real light emitting power on the transmitting circuit 131, and performing feedback adjustment. However, a collection operation, a feedback operation, or an operation of analyzing feedback information takes specific time, which may cause a control operation to be untimely, and cannot effectively protect the transmitting circuit 131 and the human eyes. In addition, a feedback circuit usually has a complex circuit structure and circuit logic that is difficult to implement, which is not conducive to reducing complexity of an entire circuit and circuit costs.

In view of this, an embodiment of this application provides a signal processing circuit, to limit duration of a valid level of a control signal by using a logical operation circuit. Because the logical operation circuit has a simple circuit structure, the signal processing circuit in this embodiment of this application can further effectively reduce circuit complexity, thereby reducing circuit costs. The signal processing circuit may be used in the lidar 100. For example, the signal processing circuit may be disposed between the control circuit 110 and the transmitting circuit 131, and is configured to: when duration of a valid level of a control signal sent by the control circuit 110 to the transmitting circuit 131 is long, output, to the transmitting circuit 131, a control signal whose valid level has short duration, to effectively protect safety of the transmitting circuit 131. The signal processing circuit may be disposed in the transmitting system 130 as shown in FIG. 2, or may be disposed in the control circuit 110, or may be disposed in another component other than the control circuit 110 and the transmitting system 130, or may exist as an independent circuit connecting the control circuit 110 and the transmitting system 130. This is not specifically limited. Certainly, the signal processing circuit may alternatively be used in another apparatus, device, or chip other than the lidar 100, for example, used in another intelligent terminal that has a driving function other than the lidar 100, or disposed in a component of another intelligent terminal. The component includes but is not limited to another sensor, for example, a controller, a chip, or a camera, and another component. Alternatively, the signal processing circuit may be used in another imaging system other than an autonomous driving system or an assisted driving system, for example, a three-dimensional building modeling system, a terrain mapping system, or a rendezvous and docking system. In addition, with evolution of a system architecture and emergence of a new scenario, the signal processing circuit provided in this embodiment of this application is also applicable to a similar technical problem. This is not specifically limited in embodiments of this application.

The following describes, by using specific embodiments, a specific structure of the signal processing circuit provided in embodiments of this application. It should be noted that the "connection" in the following embodiments of this application may refer to an electric connection, and the connection between two electrical elements may be a direct or indirect connection between the two electrical elements. For example, a connection between A and B may represent that A and B are directly connected to each other, or A and B are indirectly connected to each other through one or more other electrical elements. For example, the connection between A and B may alternatively represent that A and C are directly connected to each other, C and B are directly connected to each other, and A and B are connected to each other through C. In some scenarios, the "connection" may also be understood as coupling, for example, electromagnetic coupling between two inductors. In a word, A and B are connected, so that electric energy can be transmitted between A and B.

In addition, for ease of description, in embodiments of this application, a level 1 in a digital signal represents a high level, and a level 0 in the digital signal represents a low level. In the level 1 and the level 0 of the digital signal, "1" and "0" are "1" and "0" in a logical operation, and are not voltage values of a signal voltage of the digital signal. In most cases, the level 1 in the digital signal means that the signal voltage of the digital signal is greater than a threshold voltage, and the level 0 means that the signal voltage of the digital signal is less than the threshold voltage. The threshold voltage may be set to different values in different scenarios. For example, the threshold voltage may be 3.3 V in some scenarios, 5.5 V in some other scenarios, or 2.4 V in some other scenarios.

In addition, in the descriptions of the following embodiments of this application, a valid level is a level that can trigger a next-stage circuit to work (for example, trigger a laser to emit light), and is used to describe an amplitude of a voltage. For example, being valid at a low level means that when a voltage is lower than a voltage threshold, the next-stage circuit is triggered to work, and when a voltage is higher than or equal to the voltage threshold, the next-stage circuit does not work. Because the low level is usually described as a level 0, being valid at the low level is also referred to being valid at the level 0, or that a valid level is the level 0. Correspondingly, being valid at a high level means that when a voltage is higher than or equal to a voltage threshold, the next-stage circuit is triggered to work, and when the voltage is lower than the voltage threshold, the next-stage circuit does not work. Because the high level is usually described as a level 1, being valid at the high level is also referred to being valid at the level 1, or that a valid level is the level 1. A width is described from a time dimension, and a width of the valid level is also duration of the valid level.

In addition, phase adjustment in the following embodiments of this application means to adjust a time sequence of a signal. For example, a pulse signal is used as an example. Delaying arrival time of a pulse in the pulse signal, or making a pulse in the pulse signal arrive in advance for a period of time, or changing duration of a pulse in the pulse signal all fall within a scope of phase adjustment.

In addition, a terminal name in the following embodiments of this application is merely an example description, and may be understood as a connection terminal or a connection point, and is configured to connect to another circuit element. In another example, there may be another terminal name, a connection terminal name, or a connection point name. For example, in some scenarios, an input terminal or an output terminal may also be referred to as a communication terminal, an information transmission terminal, a port, a terminal, a connection terminal, a communication connection terminal, an information connection terminal, a connection point, a communication connection point, or an information connection point.

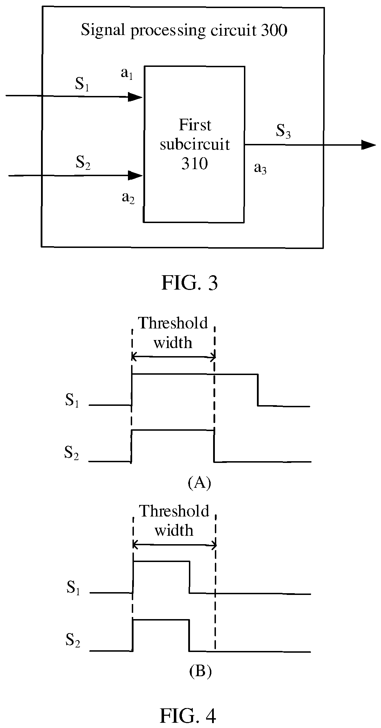

FIG. 3 is an example of a schematic diagram of a structure of a signal processing circuit according to an embodiment of this application. As shown in FIG. 3, a signal processing circuit 300 includes a first subcircuit 310. The first subcircuit 310 includes a first input terminal (ai), a second input terminal (a₂), and an output terminal (a₃). The first input terminal a₁ of the first subcircuit 310 is configured to receive a first control signal S₁, and the second input terminal a₂ of the first subcircuit 310 is configured to receive a second control signal S₂. The first subcircuit 310 may perform a logical operation on the first control signal S₁ and the second control signal S₂, and output a third control signal S₃ at the output terminal a₃ of the first subcircuit 310. A width of a valid level of the third control signal S₃ is not greater than a width of a valid level of the first control signal S₁. In this way, even if the width of the valid level of the first control signal S₁ sent by a previous-stage circuit (namely, a circuit that sends the first control signal S₁ to the signal processing circuit 300) of the signal processing circuit 300 is wide, the signal processing circuit 300 may output the third control signal S₃ whose valid level has a narrow width to a next-stage circuit (namely, a circuit that receives the third control signal S₃ sent by the signal processing circuit 300) of the signal processing circuit 300, so that the next-stage circuit can work intermittently under control of the third control signal S₃. This effectively reduces a risk of burning the next-stage circuit.

Further, for example, the first control signal S₁ may be from the previous-stage circuit of the signal processing circuit 300, for example, the control circuit 110 in FIG. 2. Subsequently, the third control signal S₃ is sent to the next-stage circuit of the signal processing circuit 300, for example, the transmitting circuit 131 in FIG. 2. The second control signal S₂ may be generated by the previous-stage circuit of the signal processing circuit 300 or the signal processing circuit 300 based on a preset or configured threshold width. The threshold width is described from a time dimension, and indicates threshold duration that affects the next-stage circuit of the signal processing circuit 300. When working duration of the next-stage circuit of the signal processing circuit 300 is less than or equal to the threshold width, it means that the next-stage circuit of the signal processing circuit 300 is not affected, that is, the next-stage circuit of the signal processing circuit 300 can still work normally. When the working duration of the next-stage circuit of the signal processing circuit 300 is greater than the threshold width, it means that the next-stage circuit of the signal processing circuit 300 is affected. For example, because the next-stage circuit of the signal processing circuit 300 is in a working state for a long time, a risk of burning the next-stage circuit is increased. For example, the threshold width may be set by the previous-stage circuit of the signal processing circuit 300 or the signal processing circuit 300 based on one or more features such as an operating characteristic, an actual service requirement, or a user requirement of the next-stage circuit of the signal processing circuit 300. In an application scenario of a lidar, the threshold width may be generally set to a value not greater than 100 ns, and preferably may be set to a value within 0 ns to 10 ns. For example, it is assumed that the threshold width is set to 5 ns. After receiving the first control signal S₁ and the second control signal S₂, the first subcircuit 310 may obtain, by performing the logical operation on the first control signal S₁ and the second control signal S₂, the third control signal S₃ that meets the following associations with the first control signal S₁.

Association 1: When a width of one valid level of the first control signal S₁ is not greater than 5 ns, the width of the valid level of the third control signal S₃ is the same as the width of the valid level of the first control signal S₁. In this condition, because the width of the valid level of the first control signal S₁ is not greater than the threshold width, it means that duration of the valid level of the first control signal S₁ is less than or equal to the threshold duration that affects the next-stage circuit, and the width of the valid level of the first control signal S₁ is within a width range that can be tolerated by the next-stage circuit. In this way, even if the third control signal S₃ whose valid level is the same as the valid level of the first control signal S₁ in width is output to the next-stage circuit, it also allows the next-stage circuit to work in a safe state. In addition, in some scenarios, the width of the valid level of the first control signal S₁ sent by the control circuit may further change continuously. However, as long as the width is within the threshold width, the width of the valid level of the third control signal S₃ output by the first subcircuit 310 can change synchronously with the width of the first control signal S₁. This helps the signal processing circuit 300 be compatible with some scenarios in which a width needs to be dynamically adjusted. Further, when the next-stage circuit is a transmitting circuit, as the width of the valid level of the first control signal S₁ continuously changes, the width of the valid level of the third control signal S₃ input to the transmitting circuit can also change in real time. In this way, duration of sending a laser signal by the transmitting circuit each time can be flexibly adjusted. This helps broaden a dynamic range of the duration of transmitting the laser signal each time, so that the signal processing circuit and the transmitting circuit can be further compatible with some scenarios in which the duration of transmitting the laser signal needs to be dynamically adjusted, for example, a pulse width anti-interference coding scenario.

Association 2: When a width of one valid level of the first control signal S₁ is greater than 5 ns, the width of the valid level of the third control signal S₃ is less than the width of the valid level of the first control signal S₁. For example, the width of the valid level of the third control signal S₃ may be a width threshold. In this condition, because the width of the valid level of the first control signal S₁ is greater than the threshold width, it means that the duration of the valid level of the first control signal S₁ is greater than the threshold duration that affects the next-stage circuit, and the width of the valid level of the first control signal S₁ exceeds a width range that can be tolerated by the next-stage circuit. Therefore, a protection mechanism can be provided for the next-stage circuit by performing the logical operation so that the width of the valid level of the third control signal S₃ is less than the width of the valid level of the first control signal S₁. In addition, the previous-stage circuit (for example, the control circuit 110) of the signal processing circuit 300 does not necessarily need to output the first control signal S₁ with a narrow width. This helps reduce a requirement on a digital resource for outputting a control signal by the previous-stage circuit, and further reduces a requirement on real-time transmission of a control signal that needs to be transmitted at a high speed. Further, when the next-stage circuit is a transmitting circuit, the transmitting circuit can be further controlled, by outputting the third control signal S₃ with a narrow width to the transmitting circuit, to intermittently send a laser signal. This can not only prevent the laser signal from being irradiated to human eyes for a long time, to effectively protect human eye safety, but also avoid a phenomenon that the transmitting circuit and an internal laser are burnt due to long-time driving of a large current, to help maintain a normal ranging function of the lidar.

It can be learned from the foregoing content that, in an application scenario of the lidar, regardless of the width of the valid level of the first control signal output by the control circuit, the signal processing circuit can output, to the transmitting circuit, the third control signal whose valid level has a narrow width, and the narrow width of the valid level may be as low as several nanoseconds. In other words, in the field of lidars, the signal processing circuit may be used as a narrow-width generation circuit, and effectively limit, by generating a control signal whose valid level has a narrow width, duration in which the transmitting circuit continuously sends the laser signal, to protect a next-stage laser circuit.

In a possible implementation, the second control signal S₂ that can implement the foregoing logical operation may be generated by the previous-stage circuit of the signal processing circuit 300 or the signal processing circuit 300 based on the first control signal S₁ and the threshold width. For example, within a width of one valid level of the first control signal S₁, the previous-stage circuit of the signal processing circuit 300 or the signal processing circuit 300 may configure a width of a first level of the second control signal S₂ to be a smallest width in the width of one valid level of the first control signal S₁ and the threshold width. The first level may be a valid level of the first control signal S₁, or may be an invalid level of the first control signal S₁, or may be a level range, where a level difference between the level range and the valid level of the first control signal S₁ is less than a value or a level difference between the level range and the valid level of the first control signal S₁ is greater than a value, or the like. This is not listed herein one by one. For ease of understanding, it is assumed that each of the valid level of the first control signal S₁ and the first level of the second control signal S₂ is a level 1. FIG. 4 is a diagram of an example of an association relationship between the second control signal and the first control signal according to an embodiment of this application. As shown in (A) in FIG. 4, when a width of the level 1 of the first control signal S₁ is greater than the threshold width, the previous-stage circuit of the signal processing circuit 300 or the signal processing circuit 300 configures a width of the level 1 of the second control signal S₂ as the threshold width. As shown in (B) in FIG. 4, when a width of the level 1 of the first control signal S₁ is less than the threshold width, the previous-stage circuit of the signal processing circuit 300 or the signal processing circuit 300 configures a width of the level 1 of the second control signal S₂ as the width of the level 1 of the first control signal S₁. In this way, after receiving the first control signal S₁ and the second control signal S₂, the first subcircuit 310 determines, in an overlapping width of the valid level of the first control signal S₁ and the first level of the second control signal S₂, that the level of the third control signal S₃ obtained through the logical operation is a valid level, and determines, in a non-overlapping width of the valid level of the first control signal S₁ and the first level of the second control signal S₂, that the level of the third control signal S₃ obtained through the logical operation is an invalid level. According to this design, when the width of the valid level of the first control signal S₁ is not greater than the threshold width, the overlapping width of the first level of the second control signal S₂ and the valid level of the first control signal S₁ is the width of the valid level of the first control signal S₁. In this way, the width of the valid level of the third control signal S₃ is consistent with the width of the valid level of the first control signal S₁. When the level of the first control signal S₁ is greater than the threshold width, the overlapping width of the first level of the second control signal S₂ and the valid level of the first control signal S₁ is the threshold width. In this way, the width of the valid level of the third control signal S₃ remains the threshold width, that is, is less than the width of the valid level of the first control signal S₁.

For ease of understanding, the following uses an example in which the signal processing circuit 300 is used in the lidar for description. In other words, an input terminal of the signal processing circuit 300 is connected to the control circuit, and an output terminal of the signal processing circuit 300 is connected to the transmitting circuit. However, it should be understood that this is merely an example provided for ease of describing the solutions. For a specific implementation of using the signal processing circuit 300 in an apparatus, a component, or a scenario, directly refer to the following content. This is not limited in embodiments of this application.

In embodiments of this application, the second control signal S₂ may be obtained in a plurality of manners. An example is as follows.

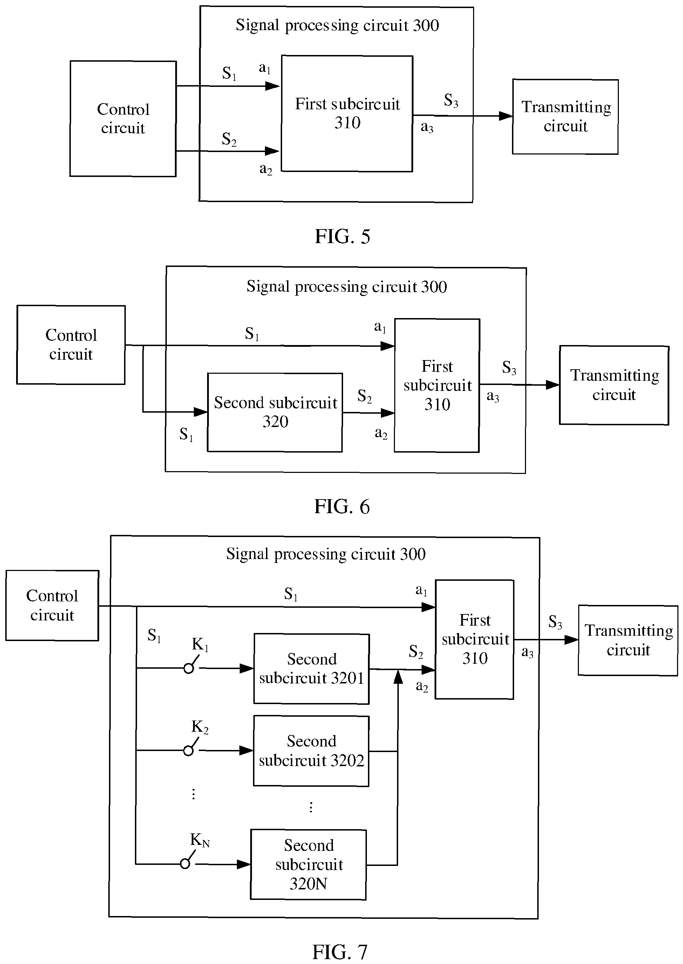

In a possible obtaining manner, FIG. 5 is a schematic diagram of an example of a connection relationship according to an embodiment of this application. As shown in FIG. 5, in this example, the first control signal S₁ and the second control signal S₂ may be from a same control circuit, and the control circuit may be, for example, the control circuit 110 in the lidar 100. The second control signal S₂ may be a fixed signal preset or configured in the control circuit, or may be automatically generated by the control circuit based on the to-be-sent first control signal S₁, for example, may be obtained by performing phase adjustment on the first control signal S₁. This is not specifically limited. In this way, the control circuit that sends the first control signal synchronously sends the second control signal, so that the control circuit can further flexibly adjust, based on an actual requirement corresponding to the first control signal, the second control signal used for the logical operation, to improve flexibility of generating the third control signal.

In another possible obtaining manner, FIG. 6 is a schematic diagram of an example of another structure of the signal processing circuit according to an embodiment of this application. As shown in FIG. 6, in this example, the signal processing circuit 300 may further include a second subcircuit 320. An input terminal of the second subcircuit 320 is configured to receive the first control signal S₁, and an output terminal of the second subcircuit 320 is configured to connect to the second input terminal a₂ of the first subcircuit 310. The second subcircuit 320 may perform phase adjustment on the first control signal S₁ received by the input terminal of the second subcircuit 320, and output the second control signal S₂ at the output terminal of the second subcircuit 320. In this example, because the second control signal is obtained by adjusting a phase of the first control signal, the second control signal may further change in real time with a change of the currently actually received first control signal, so that the second control signal can better match the first control signal in a current scenario, to improve accuracy of determining the third control signal. In addition, the second subcircuit belongs to a phase adjustment circuit, and the phase adjustment circuit has a simple circuit structure and circuit logic that is easy to implement. This helps further reduce circuit complexity and further reduce circuit costs. In addition, the second control signal is generated by using the second subcircuit disposed in the signal processing circuit. In comparison with a manner in which the control circuit synchronously sends the first control signal and the second control signal, working pressure of the control circuit can be reduced.

Further, for example, FIG. 7 is a schematic diagram of an example of still another structure of the signal processing circuit according to an embodiment of this application. As shown in FIG. 7, in this example, the signal processing circuit 300 may further include N second subcircuits that have different phase adjustment amplitudes and N switches, and the N switches are in a one-to-one correspondence with the N second subcircuits. For example, in FIG. 7, a second subcircuit 3201 corresponds to a switch K₁, a second subcircuit 3202 corresponds to a switch K₂, ..., and a second subcircuit 320N corresponds to a switch K_{N}, where N is a positive integer greater than or equal to 2. The control circuit may further be connected to control terminals of the N switches K₁ to K_{N}. The control circuit may control the N switches K₁ to K_{N} to be turned on and off, select one target second subcircuit from the N second subcircuits 3201 to 320N each time, connect a link between an input terminal of the target second subcircuit and an output terminal of the control circuit, and disconnect a link between each of input terminals of N-1 second subcircuits other than the target second subcircuit and the output terminal of the control circuit. In this way, phase adjustment is performed on the first control signal S₁ by using a phase adjustment amplitude corresponding to the target second subcircuit, to obtain the second control signal S₂ with a required phase, and flexibly adjust the width of the valid level of the third control signal S₃. For details about how to select the target second subcircuit, refer to the following signal processing circuit 1. Details are not described herein.

It should be noted that the functions of the first subcircuit and/or the second subcircuit may be directly implemented by using a connection relationship between hardware circuits, or may be implemented by encapsulating corresponding software logic in the first subcircuit and/or the second subcircuit. When implemented by using software logic, the first subcircuit and/or the second subcircuit may be considered as processing units having a computing capability. When implemented by using a hardware circuit, the first subcircuit configured to implement a logical operation capability includes but is not limited to: an AND operation circuit, a NAND operation circuit, an OR operation circuit, a NOR operation circuit, an XOR operation circuit, or the like, and the second subcircuit configured to implement a phase adjustment function includes but is not limited to: a delay chain, a phase-locked loop, a resistor-capacitor (resistor capacitance, RC) circuit, or the like. It should be understood that the first subcircuit configured to implement the logical operation capability is not limited to a digital circuit, or may be an analog circuit. This is not limited in embodiments of this application. Based on the signal processing circuit 300 shown in FIG. 6, the following describes several specific hardware circuit structures of the signal processing circuit 300 by using an example in which the first subcircuit 310 includes the foregoing logical operation circuit and the second subcircuit 320 includes the foregoing RC circuit. However, it should be understood that the following provides only several possible circuit structures, and another circuit structure or software logic that can implement a same circuit function is also included in the protection scope of embodiments of this application. This is not specifically limited in embodiments of this application. In addition, each logical operation circuit in the following may be implemented by using one gate circuit, or may be implemented by using a combination of a plurality of gate circuits. This is not specifically limited in embodiments of this application.

Before a specific circuit structure is described, some components or circuits used in the following embodiments of this application are first described.

### (1) Inverter

In embodiments of this application, the phase inverter is a component that can perform phase inversion on an input level and then output the input level. A decision threshold D for determining whether the input level is a level 0 or a level 1 is preset or configured in the phase inverter. When the input level of the phase inverter is less than the decision threshold D, the phase inverter determines that the input level is the level 0, performs phase inversion on the level 0 to obtain the level 1, and then outputs the level 1 at an output terminal of the phase inverter. On the contrary, when the input level of the phase inverter is greater than the decision threshold, the phase inverter considers that the input level is the level 1, performs phase inversion on the level 1 to obtain the level 0, and then outputs the level 0 at the output terminal of the phase inverter. When the input level of the phase inverter is equal to the decision threshold, the phase inverter considers that the input level is the level 1 or the level 0, and performs phase inversion on the level 1 or the level 0 to obtain the level 0 or the level 1.

### (2) RC delay circuit

In embodiments of this application, an integrator circuit including a resistor R and a capacitor C is referred to as an RC delay circuit. In the RC delay circuit, a second terminal of the resistor R is connected to one end of the capacitor C, and the other end of the capacitor C is grounded. That a component is grounded may mean that the component is connected to the ground by using a conductor, or may be that a grounding circuit is disposed and the component is connected to the grounding circuit. This is not specifically limited. When a level of the first terminal of the resistor R suddenly increases from a level 0 to a level 1, the level 1 first charges the capacitor C, and consequently, a level output at the second terminal of the resistor R remains the level 0 at this moment. As the capacitor C is charged gradually, the level output at the second terminal of the resistor R gradually increases. When the capacitor C is fully charged, the level output at the second terminal of the resistor R correspondingly changes to the level 1. On the contrary, when the level of the first terminal of the resistor R suddenly decreases from the level 1 to the level 0, the capacitor C starts to discharge. As a result, the level output at the second terminal of the resistor R remains the level 1 at this moment. As the capacitor C gradually discharges, the level output at the second terminal of the resistor R also gradually decreases. When the capacitor C fully discharged, the level output at the second terminal of the resistor R correspondingly changes to the level 0. In the RC delay circuit, charging or discharging time of the capacitor C is positively correlated with a product of a resistance value of the resistor R and a capacitance value of the capacitor C. The product of the resistance value of the resistor R and the capacitance value of the capacitor C is also referred to as a time constant. When the time constant is larger, a charging or discharging speed of the capacitor C is lower, that is, a speed at which the level at the second terminal of the resistor R increases or decreases is lower, and the level at the second terminal of the resistor R is less likely to change from the level 0 to the level 1 or from the level 1 to the level 0. On the contrary, when the time constant is smaller, the charging speed of the capacitor C is higher, that is, the speed at which the level at the second terminal of the resistor R increases is higher, and the level at the second terminal of the resistor R can more quickly change from the level 0 to the level 1 or from the level 1 to the level 0.

### (3) Transmitting circuit

In a lidar scenario, the transmitting circuit is a circuit that can send a laser signal. In a possible scenario example, FIG. 2 shows a possible structure of the transmitting circuit. Still refer to FIG. 2. In this example, the transmitting circuit 131 includes a resistor R₀, a laser tube, an N-channel metal-oxide semiconductor field-effect transistor (metal-oxide-semiconductor field-effect transistor, MOS), and a capacitor C₀. A first terminal of the resistor R₀ is connected to a power supply V₀, a second terminal of the resistor R₀ is connected to an input terminal of the laser tube, and an output terminal of the laser tube is connected to a drain of an NMOS₀. A source of the NMOS₀ (namely, a device marked with an inverted triangle "□" in FIG. 2) is grounded, and a gate of the NMOS₀ is configured to receive the third control signal S₃ output by the signal processing circuit 300. In addition, the second terminal of the resistor R₀ is further connected to one end of the capacitor C₀, and the other end of the capacitor C₀ is also grounded. The transmitting circuit 131 is driven by a level 1. When the level of the third control signal S₃ is the level 1, the source and the drain of the NMOS₀ are connected, so that a drive current output by the power supply V₀ can be supplied to the laser tube, to drive the laser tube to send a laser signal. When the third control signal S₃ is at a level 0, the source and the drain of the NMOS₀ are disconnected, so that the drive current output by the power supply V₀ cannot be supplied to the laser tube. In this case, the laser tube does not send a laser signal.

### (4) Level inversion circuit

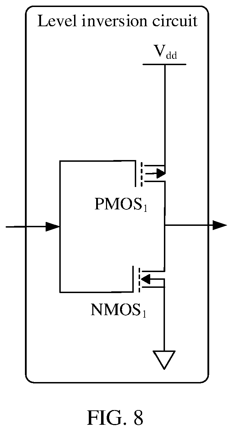

In embodiments of this application, the level inversion circuit is a circuit that can invert an input level to an inverted level for output. For example, the level inversion circuit can invert an input level 0 into a level 1 for output, and can invert an input level 1 into a level 0 for output. FIG. 8 is a schematic diagram of an example of a structure of the level inversion circuit according to an embodiment of this application. In this example, the level inversion circuit includes an NMOS₁ and a P-channel MOS, namely, a PMOS₁. A source of the PMOS₁ is connected to a power supply V_{dd}. A gate of the PMOS₁ is connected to a gate of the NMOS₁ and is used as an input terminal of the level inversion circuit to receive an input level. A drain of the PMOS₁ is connected to a drain of the NMOS₁ and is used as an output terminal of the level inversion circuit to output an output level opposite to the input level. A source of the NMOS₁ is grounded. It is assumed that the output terminal of the level inversion circuit is connected to the transmitting circuit 131 shown in FIG. 2. When the input level of the level inversion circuit is a level 1, the source and the drain of the NMOS₁ in the level inversion circuit are connected, and the source and the drain of the PMOS₁ are disconnected, so that a source level and a drain level of the NMOS₁ are the same, that is, are levels 0. The level 0 enables the source and drain of the NMOS₀ in the transmitting circuit 131 to be disconnected, so that the laser tube does not send the laser signal. When the input level is a level 0, the source and the drain of the PMOS₁ in the level inversion circuit are connected, and the source and the drain of the NMOS₁ are disconnected. In this way, a drive current output by the power supply V_{dd} can be supplied to the PMOS₁, so that the drain of the PMOS₁ outputs a level 1. The level 1 further enables the source and drain of the NMOS₀ in the transmitting circuit 131 to be connected, so that a high drive current output by the power supply V₀ can be supplied to the laser tube, to drive the laser tube to emit a high-power laser signal. It can be learned that the level inversion circuit shown in FIG. 8 can not only invert the input level 0 into the level 1 for output, but also implement a power driving function for a next-stage transmitting circuit. Therefore, in some scenarios, the level inversion circuit is also referred to as a power drive circuit.

### [Embodiment 1]: A second subcircuit includes a resistor R, a capacitor C, and a phase inverter.

### Signal processing circuit 1

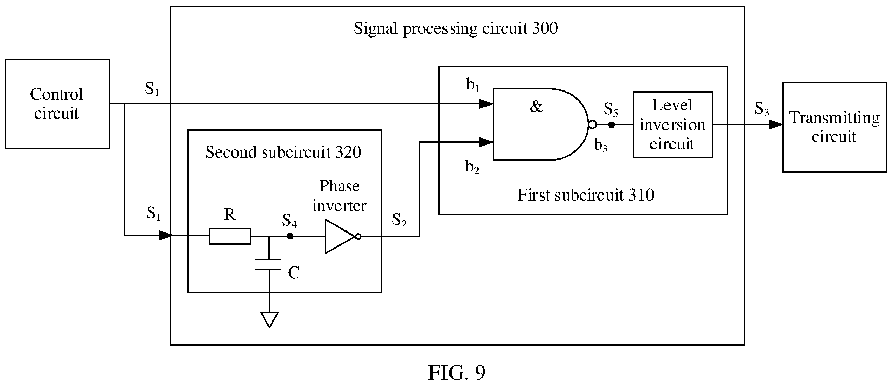

FIG. 9 is a schematic diagram of an example of a structure of a signal processing circuit according to Embodiment 1 of this application. In this example, each of the valid level of the first control signal S₁ and the valid level of the third control signal S₃ is a level 1. As shown in FIG. 9, in this example, the first subcircuit 310 includes a NAND operation circuit (namely, a device with an AND operator "&" and a NOT operator " ∘ " in FIG. 9) and a level inversion circuit, and the second subcircuit 320 includes a resistor R, a capacitor C, and a phase inverter. Both a first input terminal b₁ of the NAND operation circuit and a first terminal of the resistor R are configured to receive the first control signal S₁, a second terminal of the resistor R is connected to both an input terminal of the phase inverter and a first terminal of the capacitor C, a second terminal of the capacitor C is grounded, an output terminal of the phase inverter is connected to a second input terminal b₂ of the NAND operation circuit, an output terminal b₃ of the NAND operation circuit is connected to an input terminal of the level inversion circuit, and an output terminal of the level inversion circuit is configured to output the third control signal S₃. The first control signal S₁ output by the control circuit is directly transmitted to the first input terminal b₁ of the NAND operation circuit, and is transmitted to the first terminal of the resistor R. After the first control signal S₁ is delayed by an RC circuit, a fourth control signal S₄ is output at the second terminal of the resistor R. After the phase inverter performs phase inversion on the fourth control signal S₄, the second control signal S₂ is output at the output terminal of the phase inverter, and then the second control signal S₂ is transmitted to the second input terminal b₂ of the NAND operation circuit. After the NAND operation circuit performs a NAND operation on the first control signal S₁ received by the first input terminal b₁ and the second control signal S₂ received by the second input terminal b₂, a fifth control signal S₅ is output at the output terminal b₃ of the NAND operation circuit, and the fifth control signal S₅ is inverted into the third control signal S₃ by using the level inverter.

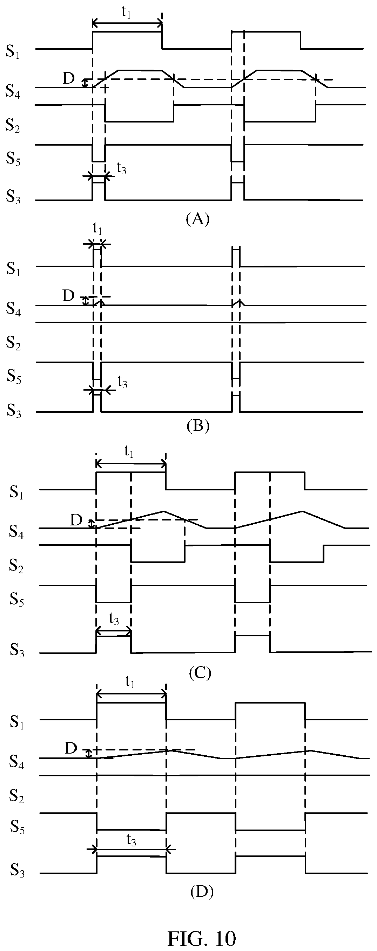

FIG. 10 is a schematic diagram of an example of a time sequence of each control signal in the foregoing signal processing circuit. In the time sequence diagram, a horizontal axis represents time, a vertical axis represents an amplitude, t₁ is a width of one valid level 1 of the first control signal S₁, D is a decision threshold of the phase inverter, and t₃ is a width of one valid level 1 of the third control signal S₃. (A) in FIG. 10 is a diagram of a time sequence in a case in which the width t₁ of the level 1 of the first control signal S₁ is large, and (B) in FIG. 10 is a diagram of a time sequence in a case in which the width t₁ of the level 1 of the first control signal S₁ is small.

Refer to FIG. 9 and (A) in FIG. 10. After the level of the first control signal S₁ changes from a level 0 to the level 1, the level 1 is directly input to the first input terminal b₁ of the NAND operation circuit. In addition, the level 1 passes through the RC delay circuit, and charges the capacitor C. In this way, a level of the fourth control signal S₄ output at the second terminal of the resistor R gradually increases from the level 0 as the capacitor C is charged. In the first t₃ width of the width t₁, although the level of the fourth control signal S₄ increases, the level of the fourth control signal S₄ does not exceed the decision threshold D of the phase inverter. Therefore, the phase inverter determines that an input level is less than the decision threshold D, that is, considers that the input level is the level 0. The phase inverter performs phase inversion on the level 0, so that the level of the second control signal S₂ output at the output terminal of the phase inverter is the level 1. After the NAND operation circuit performs the NAND operation on the first control signal S₁ whose level is 1 and the second control signal S₂ whose level is 1, a level of the fifth control signal S₅ output at the output terminal b₃ of the NAND operation circuit is the level 0. Further, after inversion by the level inversion circuit, a level of the third control signal S₃ output at the output terminal of the level inversion circuit is the level 1. After the first t₃ width of the width t₁, the level of the fourth control signal S₄ increases to exceed the decision threshold D of the phase inverter. The phase inverter determines that the input level is greater than the decision threshold D, that is, considers that the input level is the level 1. Therefore, the phase inverter performs phase inversion on the level 1, so that the level of the second control signal S₂ output at the output terminal of the phase inverter is the level 0. After the NAND operation circuit performs the NAND operation on the first control signal S₁ whose level is 1 and the second control signal S₂ whose level is 0, the level of the fifth control signal S₅ output at the output terminal b₃ of the NAND operation circuit is the level 1. Further, after inversion by the level inversion circuit, the level of the third control signal S₃ output at the output terminal of the level inversion circuit is the level 0. Then, after the level of the first control signal S₁ changes from the level 1 to the level 0, the level 0 is directly input to the first input terminal b₁ of the NAND operation circuit, and passes through the RC delay circuit. The level of the fourth control signal S₄ output at the second terminal of the resistor R gradually decreases from the level 1 as the capacitor discharges. Before the level of the fourth control signal S₄ decreases to be less than the decision threshold D of the phase inverter, the phase inverter determines that the input level is not less than the decision threshold D, that is, considers that the input level is still the level 1. The phase inverter performs phase inversion on the level 1, so that the level of the second control signal S₂ output at the output terminal of the phase inverter is still the level 0. After the level of the fourth control signal S₄ decreases to be less than the decision threshold D of the phase inverter, the phase inverter determines that the input level is less than the decision threshold D, that is, considers that the input level changes to the level 0. The phase inverter performs phase inversion on the level 0, so that the level of the second control signal S₂ output at the output terminal of the phase inverter is converted from the level 0 to the level 1. However, regardless of a state of the level of the second control signal S₂, after the NAND operation circuit performs the NAND operation on the first control signal S₁ whose level is the level 0 and the second control signal S₂ in any level state, the level of the fifth control signal S₅ output at the output terminal b₃ of the NAND operation circuit is the level 1. Further, after inversion by the level inversion circuit, the level of the third control signal S₃ output at the output terminal of the level inversion circuit is the level 0.

Refer to FIG. 9 and (B) in FIG. 10. After the level of the first control signal S₁ changes from a level 0 to the level 1, the level 1 is directly input to the first input terminal b₁ of the NAND operation circuit, and the capacitor is charged through the RC delay circuit, so that a level of the fourth control signal S₄ output at the second terminal of the resistor R gradually increases from the level 0. In the entire width t₁, although the level of the fourth control signal S₄ continuously increases, the level of the fourth control signal S₄ does not exceed the decision threshold D of the phase inverter. Therefore, the phase inverter determines that an input level is always less than the decision threshold D, that is, considers that the input level is the level 0. The phase inverter performs phase inversion on the level 0, so that the level of the second control signal S₂ output at the output terminal of the phase inverter is always the level 1. After the NAND operation circuit performs the NAND operation on the first control signal S₁ whose level is 1 and the second control signal S₂ whose level is 1, a level of the fifth control signal S₅ output at the output terminal b₃ of the NAND operation circuit is always the level 0. After inversion by the level inversion circuit, a level of the third control signal S₃ output at the output terminal of the level inversion circuit is always the level 1. After the level of the first control signal S₁ changes from the level 1 to the level 0, the level 0 is directly input to the first input terminal b₁ of the NAND operation circuit. Therefore, regardless of a state of the level of the second control signal S₂, after the NAND operation circuit performs the NAND operation on the first control signal S₁ whose level is 0 and the second control signal S₂ in any level state, the level of the fifth control signal S₅ output at the output terminal b₃ of the NAND operation circuit is always the level 1. After inversion by the level inversion circuit, the level of the third control signal S₃ output at the output terminal of the level inversion circuit is always the level 0.

It can be learned that, the signal processing circuit 300 in FIG. 9 is used. In the first t₃ width in which the level of the first control signal S₁ changes from the level 0 to the level 1 each time, the laser tube in the transmitting circuit is driven by the level 1 to send a laser signal. In a width other than the first t₃ width, the laser tube in the transmitting circuit receives the level 0, and the laser tube is not driven to send a laser signal. The t₃ width may be less than the width t₁ of one level 1 of the first control signal S₁, as shown in (A) in FIG. 10, or may be equal to the width t₁ of one level 1 of the first control signal S₁, as shown in (B) in FIG. 10. That is, regardless of the width t₁ of one level 1 of the first control signal S₁, the signal processing circuit 300 can control the laser tube to emit light intermittently, so as to protect the laser tube. In addition, the width t₃ is actually determined by both the width t₁ of one level 1 of the first control signal S₁ and a width (which may be considered as the foregoing threshold width) in which the level of the fourth control signal S₄ increases from the level 0 to the decision threshold D. When the width in which the level of the fourth control signal S₄ increases from the level 0 to the decision threshold D is less than the width t₁ of one level 1 of the first control signal S₁, in the entire width t₁, the level of the fourth control signal S₄ is first less than the decision threshold D and then greater than the decision threshold D. In this way, the level of the second control signal S₂ is first the level 1 and then the level 0, and the level of the third control signal S₃ is first the level 1 and then the level 0. That is, the width t₃ of the level 1 of the third control signal S₃ is the width in which the level of the fourth control signal S₄ increases from the level 0 to the decision threshold D. When the width in which the level of the fourth control signal S₄ increases from the level 0 to the decision threshold D is not less than the width t₁ of the level 1 of the first control signal S₁, in the entire width t₁, the level of the fourth control signal S₄ is always the level 0. In this way, the level of the second control signal S₂ is always the level 1, and the level of the third control signal S₃ is always the level 1. That is, the width t₃ of the level 1 of the third control signal S₃ is the width t₁ of the level 1 of the first control signal S₁. It can be learned that the signal processing circuit 300 in FIG. 9 can limit the width of the valid level of the output third control signal S₃ within the threshold width by using a logical operation, and can further flexibly output, when the level of the first control signal S₁ is not greater than the threshold width, the third control signal S₃ whose valid level is the same as the first control signal S₁ in width.

Further, the width in which the level of the fourth control signal S₄ increases from the level 0 to the decision threshold D is related to the time constant of the RC delay circuit and the decision threshold D of the phase inverter. When the time constant is fixed, a change slope of the level of the fourth control signal S₄ is fixed. Therefore, if the decision threshold D is larger, the level of the fourth control signal S₄ is less likely to exceed the decision threshold D, that is, the second control signal S₂ is at the level 1 for a longer time. In this way, the width t₃ of the valid level of the third control signal S₃ is larger. On the contrary, if the decision threshold D is smaller, the level of the fourth control signal S₄ is more likely to exceed the decision threshold D, that is, the second control signal S₂ is at the level 1 for a shorter time. In this way, the width t₃ of the valid level of the third control signal S₃ is smaller. It can be learned that the decision threshold D is in a positive correlation relationship with the width in which the level of the fourth control signal S₄ increases from the level 0 to the decision threshold D. Similarly, when the decision threshold D is fixed, if the time constant is smaller, a speed at which the level of the fourth control signal S₄ increases is higher, the change slope of the level of the fourth control signal S₄ is larger, and the level of the fourth control signal S₄ is more likely to exceed the decision threshold D. In this way, the width t₃ of the valid level of the third control signal S₃ is smaller. On the contrary, if the time constant is smaller, the speed at which the level of the fourth control signal S₄ increases is lower, the change slope of the level of the fourth control signal S₄ is smaller, and the level of the fourth control signal S₄ is less likely to exceed the decision threshold D. In this way, the width t₃ of the valid level of the third control signal S₃ is larger. It can be learned that the time constant is also in a positive correlation relationship with the width in which the level of the fourth control signal S₄ increases from the level 0 to the decision threshold D. For ease of understanding, (A) in FIG. 10, (C) in FIG. 10, and (D) in FIG. 10 are diagrams of time sequences corresponding to different time constants under the same first control signal S₁.

(A) in FIG. 10 is a diagram of a time sequence in a case in which the time constant of the RC delay circuit is extremely small. As shown in (A) in FIG. 10, after the level of the first control signal S₁ received at the first terminal of the resistor R changes from the level 0 to the level 1, because the time constant is extremely small, the change slope of the level of the fourth control signal S₄ is extremely large. As a result, the level of the fourth control signal S₄ quickly changes from the level 0 to the level 1 and then remains at the level 1 until the first control signal S₁ received at the first terminal of the resistor R changes to the level 0. In addition, because the level of the fourth control signal S₄ increases rapidly, the level of the fourth control signal S₄ quickly exceeds the decision threshold D of the phase inverter. As a result, the level of the second control signal S₂ output at the output terminal of the phase inverter can also quickly change from the level 1 to the level 0, so that the width t₃ of the valid level of the third control signal S₃ is extremely small.

(C) in FIG. 10 is a diagram of a time sequence in a case in which the time constant of the RC delay circuit is large. After the level of the first control signal S₁ received by the first terminal of the resistor R changes from the level 0 to the level 1, because the time constant is large, the change slope of the level of the fourth control signal S₄ is small. As a result, the level of the fourth control signal S₄ gradually increases from the level 0 to the decision threshold D and then continues to increase. When the level of the first control signal S₁ received by the first terminal of the resistor R changes to the level 0, the level of the fourth control signal S₄ ends to increase. In addition, because the level of the fourth control signal S₄ increases slowly, time required for the level of the fourth control signal S₄ to exceed the decision threshold D of the phase inverter is long. As a result, time required for the level of the second control signal S₂ output at the output terminal of the phase inverter to change from the level 1 to the level 0 is long. In this way, the width t₃ of the valid level of the third control signal S₃ is large, but the width t₃ is still less than the width t₁ of the first control signal S₁.

(D) in FIG. 10 is a diagram of a time sequence in a case in which the time constant of the RC delay circuit is extremely large. After the level of the first control signal S₁ received by the first terminal of the resistor R changes from the level 0 to the level 1, because the time constant is extremely large, the change slope of the level of the fourth control signal S₄ is extremely small. As a result, the level of the fourth control signal S₄ extremely slowly increases from the level 0. When the level of the first control signal S₁ received by the first terminal of the resistor R changes to the level 0, the level of the fourth control signal S₄ does not increase to the decision threshold D of the phase inverter. As a result, the level of the second control signal S₂ output at the output terminal of the phase inverter remains at the level 1, and the width t₃ of the valid level of the third control signal S₃ is actually the same as the width t₁ of the first control signal S₁. It should be noted that, an extremely large time constant is used in (D) in FIG. 10, the width t₃ of the valid level of the third control signal S₃ is also extremely large. Therefore, a scenario shown in (D) in FIG. 10 is not applicable to a scenario in which the lidar needs to decrease the width of the valid level of the control signal S₁.

Based on the foregoing content, to flexibly adjust the width t₃ of the valid level of the third control signal S₃, the control circuit may further adjust the decision threshold D and/or the time constant by using the following adjustment solution 1 and/or adjustment solution 2:

In the adjustment solution 1, the control circuit may further be connected to the phase inverter. When the control circuit needs to increase the width t₃ of the valid level of the third control signal S₃, the control circuit may control the phase inverter to increase the decision threshold D, so that the level of the fourth control signal S₄ is less likely to exceed the decision threshold D, time required for the level of the fourth control signal S₄ to increase from the level 0 to the decision threshold D is prolonged, and time in which the level of the third control signal S₃ is at the level 1 is correspondingly prolonged, to increase the width t₃ of the third control signal S₃ at the level 1. On the contrary, when the control circuit needs to decrease the width t₃ of the valid level of the third control signal S₃, the control circuit may control the phase inverter to decrease the decision threshold D, so that the level of the fourth control signal S₄ is more likely to exceed the decision threshold D, the time required for the level of the fourth control signal S₄ to increase from the level 0 to the decision threshold D is shortened, and the time in which the level of the third control signal S₃ is at the level 1 is correspondingly shortened, to decrease the width t₃ of the third control signal S₃ at the level 1.

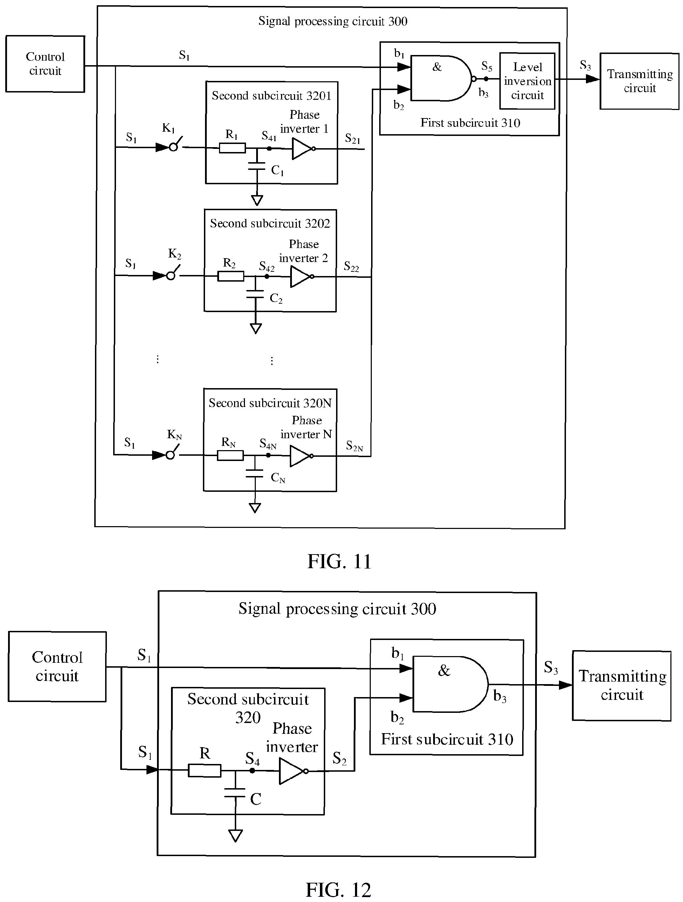

In the adjustment solution 2, FIG. 11 is a schematic diagram of an example of another structure of the signal processing circuit according to Embodiment 1 of this application. The signal processing circuit 300 is a refinement of the signal processing circuit 300 shown in FIG. 7, that is, each second subcircuit includes an RC delay circuit and a phase inverter. Widths of valid levels of output signals (namely, control signals S₂₁ to S_{2N}) of any two of the N second subcircuits are different. For example, resistance values of resistors and/or capacitance values of capacitors in the any two second subcircuits are different, so that time constants corresponding to the N second subcircuits are different, and widths of valid levels of control signals S₄₁ to S_{4N} are different. Alternatively, decision thresholds D of inverters in any two of the N second subcircuits are different. Alternatively, some second subcircuits are controlled by using time constants, and some subcircuits are controlled by using decision thresholds D of inverters, so that the widths of the valid levels of the output signals S₂₁ to S_{2N} are different from each other. When the width of the valid level of the third control signal S₃ needs to be decreased, the control circuit may select, from the N second subcircuits, a target second subcircuit whose time constant is less than a currently used time constant, turn on a switch corresponding to the target second subcircuit, and turn off switches corresponding to the other N-1 second subcircuits, so that the level of the fourth control signal S₄ is more likely to exceed the decision threshold D by using a second subcircuit with a smaller time constant, to decrease the width of the valid level of the third control signal S₃. On the contrary, when the valid level of the third control signal S₃ needs to have a large width, the control circuit may select, from the N second subcircuits, a target second subcircuit whose time constant is greater than the currently used time constant, turn on a switch corresponding to the target second subcircuit, and turn off switches corresponding to the other N-1 second subcircuits, so that the level of the fourth control signal is less likely to exceed the decision threshold D by using a second subcircuit with a larger time constant, to increase the width of the valid level of the third control signal S₃.

It should be noted that, in the foregoing adjustment solution 2, when a plurality of second subcircuits meet a condition (that is, time constants of the plurality of second subcircuits are greater than the time constant of the currently used second subcircuit, or less than the time constant of the currently used second subcircuit), the control signal may randomly select one of the second subcircuits for use, or may select a second subcircuit with a largest time constant for use, to adjust to a required width as soon as possible, or may select a second subcircuit with a smallest time constant for use, to maintain a stable state of the entire circuit as much as possible by changing a time constant level by level. Certainly, another rule may be used for selection. This is not specifically limited.

### Signal processing circuit 2

FIG. 12 is a schematic diagram of an example of a structure of another signal processing circuit according to Embodiment 1 of this application. In this example, each of the valid level of the first control signal S₁ and the valid level of the third control signal S₃ is a level 1. As shown in FIG. 12, in this example, the first subcircuit 310 includes an AND operation circuit (namely, a device with an AND operation symbol "&" in FIG. 12), and the second subcircuit 320 includes a resistor R, a capacitor C, and a phase inverter. Both a first input terminal b₁ of the AND operation circuit and a first terminal of the resistor R are configured to receive the first control signal S₁, a second terminal of the resistor R is connected to both an input terminal of the phase inverter and a first terminal of the capacitor C, a second terminal of the capacitor C is grounded, an output terminal of the phase inverter is connected to a second input terminal b₂ of the AND operation circuit, and an output terminal b₃ of the AND operation circuit is configured to output the third control signal S₃. The first control signal S₁ output by the control circuit is directly transmitted to the first input terminal b₁ of the AND operation circuit, and is transmitted to the resistor R. After the first control signal S₁ is delayed by an RC circuit, a fourth control signal S₄ is output at the second terminal of the resistor R. After the phase inverter performs phase inversion on the fourth control signal S₄, the second control signal S₂ is output at the output terminal of the phase inverter, and then the second control signal S₂ is transmitted to the second input terminal b₂ of the AND operation circuit. After the AND operation circuit performs an AND operation on the first control signal S₁ received by the first input terminal b₁ and the second control signal S₂ received by the second input terminal b₂, the third control signal S₃ is output at the output terminal b₃ of the AND operation circuit.

It should be noted that, for a diagram of a time sequence of each node in the signal processing circuit 2, refer to the descriptions of the foregoing signal processing circuit 1. A difference lies in: In the foregoing signal processing circuit 1, the fifth control signal S₅ whose level is opposite to the level of the third control signal S₃ is first obtained by performing an operation by using the NAND operation circuit, and then the level of the fifth control signal S₅ is inverted by the level inversion circuit to obtain the third control signal S₃. Instead, in the signal processing circuit 2, the AND operation circuit directly performs the AND operation on the first control signal S₁ input at the first input terminal b₁ and the second control signal S₂ input at the second input terminal b₂, to directly output the third control signal S₃ at the output terminal b₃. In addition, the foregoing signal processing circuit 1 synchronously implements, by using the level inversion circuit, objectives of inverting the level 0 to the level 1 and power driving. Therefore, when the output terminal of the AND operation circuit directly outputs the level 1, if a corresponding power driving function needs to be further added, power driving may be implemented synchronously in the operation circuit, or may be implemented by adding an additional power drive circuit. When the power drive circuit is added, a difference between the power drive circuit and the level inversion circuit lies in that positions of a PMOS₁ and an NMOS₁ are exchanged. In this way, when a level 1 is input to an input terminal of the power drive circuit, the NMOS₁ whose source is connected to a power supply V_{dd} is conducted, and the PMOS₁ whose source is grounded is not conducted, so that the power supply V_{dd} can provide a high drive current to the transmitting circuit by using the conducted NMOS₁, to transmit a laser signal with high power. In addition, the signal processing circuit 2 may alternatively change a decision threshold and/or a time constant of the phase inverter by using the control circuit, to flexibly adjust the width of the valid level of the third control signal S₃. For a specific implementation operation, refer to the descriptions of the foregoing signal processing circuit 1. Details are not described in embodiments of this application again.

### Signal processing circuit 3

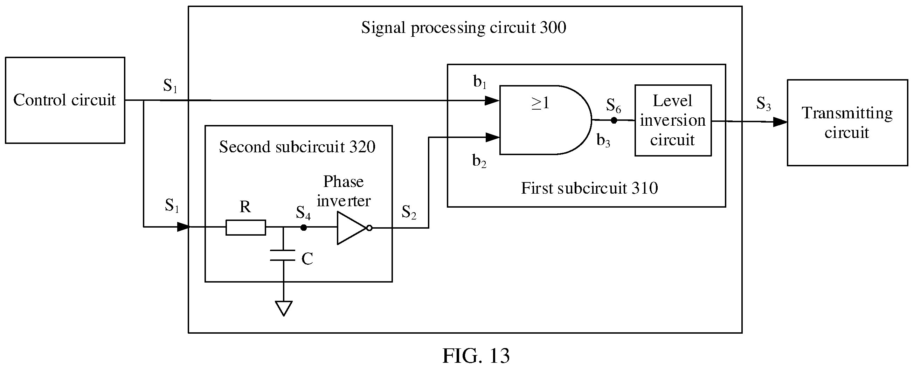

FIG. 13 is a schematic diagram of an example of a structure of still another signal processing circuit according to Embodiment 1 of this application. In this example, the valid level of the first control signal S₁ is a level 0, and the valid level of the third control signal S₃ is a level 1. As shown in FIG. 13, in this example, the first subcircuit 310 includes an OR operation circuit (namely, a device with an OR operation symbol "≥1" in FIG. 13) and a level inversion circuit, and the second subcircuit 320 includes a resistor R, a capacitor C, and a phase inverter. Both a first input terminal b₁ of the OR operation circuit and a first terminal of the resistor R are configured to receive the first control signal S₁, a second terminal of the resistor R is connected to both an input terminal of the phase inverter and a first terminal of the capacitor C, a second terminal of the capacitor C is grounded, an output terminal of the phase inverter is connected to a second input terminal b₂ of the OR operation circuit, an output terminal b₃ of the OR operation circuit is connected to an input terminal of a level inversion circuit, and an output terminal of the level inversion circuit is configured to output the third control signal S₃. The first control signal S₁ output by the control circuit is directly transmitted to the first input terminal b₁ of the OR operation circuit, and is transmitted to the resistor R. After an RC circuit delays the first control signal S₁, a fourth control signal S₄ is output at the second terminal of the resistor R. After the phase inverter performs phase inversion on the fourth control signal S₄, the second control signal S₂ is output at the output terminal of the phase inverter, and the second control signal S₂ is transmitted to the second input terminal b₂ of the OR operation circuit. After the OR operation circuit performs an OR operation on the first control signal S₁ received by the first input terminal b₁ and the second control signal S₂ received by the second input terminal b₂, a sixth control signal S₆ is output at the output terminal b₃ of the OR operation circuit. After the level inversion circuit performs level inversion on the sixth control signal S₆, the third control signal S₃ is output at the output terminal of the level inversion circuit.

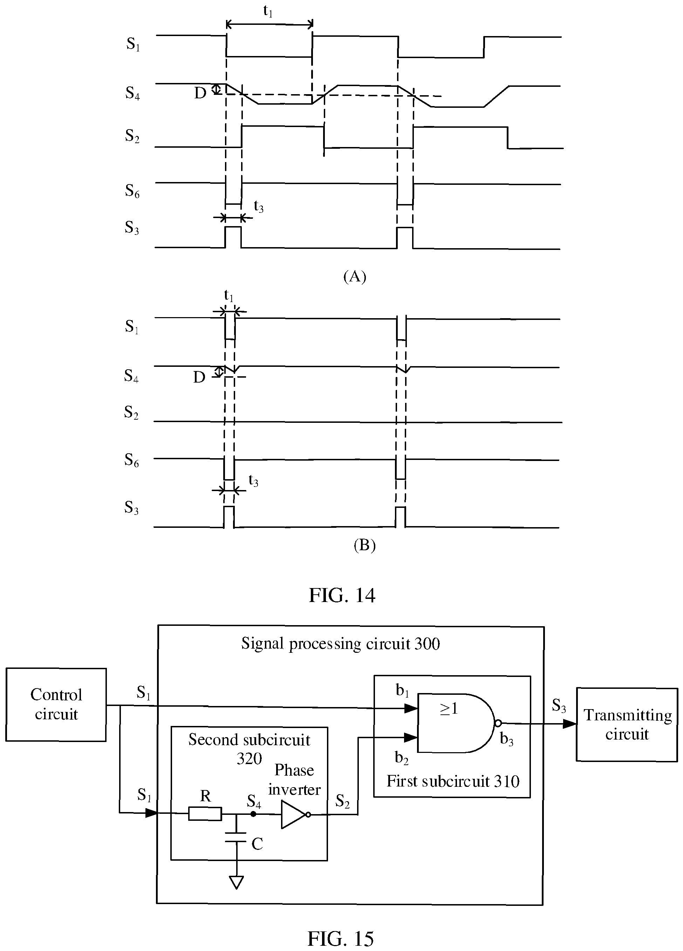

FIG. 14 is a schematic diagram of an example of a time sequence of each control signal in the foregoing signal processing circuit. In this example, t₁ is a width of one valid level 0 of the first control signal S₁, D is a decision threshold of the phase inverter, and t₃ is a width of one valid level 1 of the third control signal S₃. (A) in FIG. 14 is a diagram of a time sequence in a case in which the width t₁ of one level 0 of the first control signal S₁ is large, and (B) in FIG. 14 is a diagram of a time sequence in a case in which the width t₁ of one level 0 of the first control signal S₁ is small.

Refer to FIG. 13 and (A) in FIG. 14. After the level of the first control signal S₁ changes from the level 1 to the level 0, the level 0 is directly input to the first input terminal b₁ of the OR operation circuit. In addition, the level 0 passes through the RC delay circuit, and the capacitor C is discharged, so that a level of the fourth control signal S₄ output at the second terminal of the resistor R gradually decreases from the level 1. In the first t₃ width of the width t₁, although the level of the fourth control signal S₄ decreases, the level of the fourth control signal S₄ is not less than the decision threshold D of the phase inverter. Therefore, the phase inverter determines that an input level is not less than the decision threshold D, that is, considers that the input level is the level 1. The phase inverter performs phase inversion on the level 1, so that the level of the second control signal S₂ output at the output terminal of the phase inverter is the level 0. After the OR operation circuit performs the OR operation on the first control signal S₁ whose level is 0 and the second control signal S₂ whose level is 0, a level of the sixth control signal S₆ output at the output terminal b₃ of the OR operation circuit is the level 0. Further, after inversion by the level inversion circuit, a level of the third control signal S₃ output at the output terminal of the level inversion circuit is the level 1. After the first t₃ width of the width t₁, the level of the fourth control signal S₄ is less than the decision threshold D of the phase inverter. The phase inverter determines that the input level is less than the decision threshold D, that is, considers that the input level is the level 0. Therefore, the phase inverter performs phase inversion on the level 0, so that the level of the second control signal S₂ output at the output terminal of the phase inverter is the level 1. After the OR operation circuit performs the OR operation on the first control signal S₁ whose level is 0 and the second control signal S₂ whose level is 1, the level of the sixth control signal S₆ output at the output terminal b₃ of the OR operation circuit is the level 1. Further, after inversion by the level inversion circuit, the level of the third control signal S₃ output at the output terminal of the level inversion circuit is the level 0. Then, after the level of the first control signal S₁ changes from the level 0 to the level 1, the level 1 is directly input to the first input terminal b₁ of the OR operation circuit. In addition, the level 1 passes through the RC delay circuit, and charges the capacitor C. In this way, the level of the fourth control signal S₄ output at the second terminal of the resistor R gradually increases from the level 0. In this way, the level of the second control signal S₂ is first the level 1 and then changes to the level 0. Regardless of a state of the level of the second control signal S₂, after the OR operation circuit performs the OR operation on the first control signal S₁ whose level is the level 1 and the second control signal S₂ in any level state, the level of the sixth control signal S₆ output at the output terminal b₃ of the OR operation circuit is the level 1. Further, after inversion by the level inversion circuit, the level of the third control signal S₃ output at the output terminal of the level inversion circuit is the level 0. It can be learned that, when the width t₁ of one valid level 0 of the first control signal S₁ is large, the signal processing circuit shown in FIG. 13 can output the third control signal S₃, where the width t₃ of the valid level 1 of the third control signal S₃ is less than t₁. This effectively limits transmission duration of the transmitting circuit.

Refer to FIG. 13 and (B) in FIG. 14. After the level of the first control signal S₁ changes from the level 1 to the level 0, the level 0 is directly input to the first input terminal b₁ of the OR operation circuit. In addition, the level 0 passes through the RC delay circuit, and the capacitor C is discharged, so that a level of the fourth control signal S₄ output at the second terminal of the resistor R gradually decreases from the level 1. In the entire width t₁, although the level of the fourth control signal S₄ continuously decreases, the level of the fourth control signal S₄ is not less than the decision threshold D of the phase inverter. Therefore, the phase inverter determines that an input level is always not less than the decision threshold D, that is, considers that the input level is the level 1. The phase inverter performs phase inversion on the level 1, so that the level of the second control signal S₂ output at the output terminal of the phase inverter is always the level 0. After the OR operation circuit performs the OR operation on the first control signal S₁ whose level is 0 and the second control signal S₂ whose level is 0, a level of the sixth control signal S₆ output at the output terminal b₃ of the AND operation circuit is the level 0. Further, after inversion by the level inversion circuit, a level of the third control signal S₃ output at the output terminal of the level inversion circuit is the level 1. After the level of the first control signal S₁ changes from the level 0 to the level 1, the level 1 is directly input to the first input terminal b₁ of the OR operation circuit. Therefore, regardless of a state of the level of the second control signal S₂, after the OR operation circuit performs the OR operation on the first control signal S₁ whose level is 1 and the second control signal S₂ in any level state, the level of the sixth control signal S₆ output at the output terminal b₃ of the OR operation circuit is the level 1. Further, after inversion by the level inversion circuit, the level of the third control signal S₃ output at the output terminal of the level inversion circuit is the level 0. It can be learned that, when the width t₁ of the valid level 0 of the first control signal S₁ is small, the signal processing circuit shown in FIG. 13 can further output the third control signal S₃, to flexibly adjust, as the first control signal S₁ changes, duration of transmitting the laser signal by the transmitting circuit, where the width t₃ of the valid level 1 of the third control signal S₃ is equal to t₁.

It should be noted that the signal processing circuit 3 may alternatively change a decision threshold and/or a time constant of the phase inverter by using the control circuit, to flexibly adjust the width of the valid level of the third control signal S₃. For a specific implementation operation, refer to the descriptions of the foregoing signal processing circuit 1. Details are not described in embodiments of this application again.

### Signal processing circuit 4

FIG. 15 is a schematic diagram of an example of a structure of still another signal processing circuit according to Embodiment 1 of this application. In this example, the valid level of the first control signal S₁ is a level 0, and the valid level of the third control signal S₃ is a level 1. As shown in FIG. 15, in this example, the first subcircuit 310 includes a NOR operation circuit (namely, a device with an OR operator "≥1" and a NOT operator " ∘ " in FIG. 13), and the second subcircuit 320 includes a resistor R, a capacitor C, and a phase inverter. Both a first input terminal b₁ of the NOR operation circuit and a first terminal of the resistor R are configured to receive the first control signal S₁, a second terminal of the resistor R is connected to both an input terminal of the phase inverter and a first terminal of the capacitor C, a second terminal of the capacitor C is grounded, an output terminal of the phase inverter is connected to a second input terminal b₂ of the NOR operation circuit, and an output terminal b₃ of the NOR operation circuit is configured to output the third control signal S₃. The first control signal S₁ output by the control circuit is directly transmitted to the first input terminal b₁ of the NOR operation circuit, and is transmitted to the resistor R. After the first control signal S₁ is delayed by an RC circuit, a fourth control signal S₄ is output at the second terminal of the resistor R. After the phase inverter performs phase inversion on the fourth control signal S₄, the second control signal S₂ is output at the output terminal of the phase inverter, and then the second control signal S₂ is transmitted to the second input terminal b₂ of the NOR operation circuit. After the NOR operation circuit performs an NOR operation on the first control signal S₁ received by the first input terminal b₁ and the second control signal S₂ received by the second input terminal b₂, the third control signal S₃ is output at the output terminal b₃ of the NOR operation circuit.

It should be noted that, for a diagram of a time sequence of each node in the signal processing circuit 4, refer to the descriptions of the foregoing signal processing circuit 3. A difference lies in: In the foregoing signal processing circuit 3, the OR operation is first performed on the first control signal S₁ and the second control signal S₂ to obtain the sixth control signal S₆ whose level is opposite to the level of the third control signal, and then level inversion is performed on the sixth control signal S₆ to obtain the third control signal S₃. Instead, in the signal processing circuit 4, the NOR operation circuit directly performs the NOR operation on the first control signal S₁ input at the first input terminal b₁ and the second control signal S₂ input at the second input terminal b₂, to directly output the third control signal S₃ at the output terminal b₃ of the NOR operation circuit. In addition, the signal processing circuit 4 may alternatively perform power driving on the third control signal S₃. A power drive circuit may be synchronously implemented in the NOR operational circuit, or may be implemented by adding an additional power drive circuit. For the power drive circuit, refer to the descriptions of the foregoing signal processing circuit 2. Details are not described in embodiments of this application again. In addition, the signal processing circuit 4 may alternatively change a decision threshold and/or a time constant of the phase inverter by using the control circuit, to flexibly adjust the width of the valid level of the third control signal S₃. For a specific implementation operation, refer to the descriptions of the foregoing signal processing circuit 1. Details are not described in embodiments of this application again.

### Signal processing circuit 5

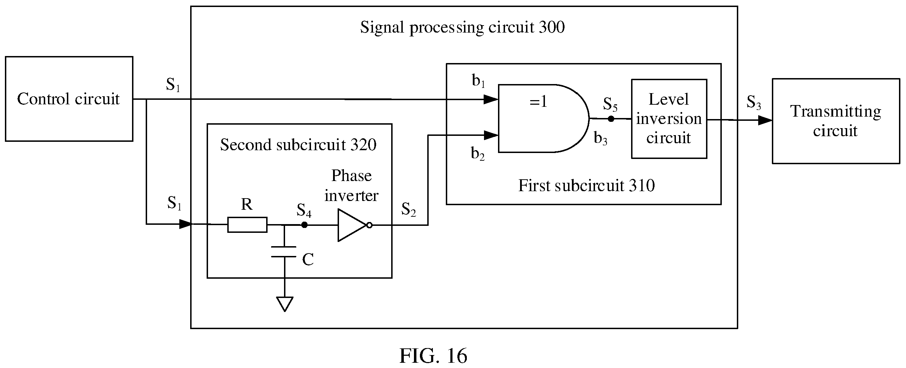

FIG. 16 is a schematic diagram of an example of a structure of still another signal processing circuit according to Embodiment 1 of this application. As shown in FIG. 16, in this example, the first subcircuit 310 includes an XOR operation circuit (namely, a device with an XOR operation symbol "=1" in FIG. 16) and a level inversion circuit, and the second subcircuit 320 includes a resistor R, a capacitor C, and a phase inverter. Both a first input terminal b₁ of the XOR operation circuit and a first terminal of the resistor R are configured to receive the first control signal S₁, a second terminal of the resistor R is connected to both a first terminal of the capacitor C and an input terminal of the phase inverter, a second terminal of the capacitor C is grounded, an output terminal of the phase inverter is connected to a second input terminal b₂ of the XOR operation circuit, an output terminal b₃ of the XOR operation circuit is connected to an input terminal of a level inversion circuit, and an output terminal of the level inversion circuit is configured to output the third control signal S₃. The first control signal S₁ output by the control circuit is directly input to the first input terminal b₁ of the XOR operation circuit, and is delayed by an RC circuit, and a fourth control signal S₄ is output at the second terminal of the resistor R. After the phase inverter converts the fourth control signal S₄ into the second control signal S₂, the second control signal S₂ is transmitted to the second input terminal b₂ of the XOR operation circuit. After the XOR operation circuit performs an XOR operation on the first control signal S₁ received by the first input terminal b₁ and the second control signal S₂ received by the second input terminal b₂, a fifth control signal S₅ is output at the output terminal b₃ of the XOR operation circuit. After inversion by the level inversion circuit, the third control signal S₃ is output at the output terminal of the level inversion circuit.

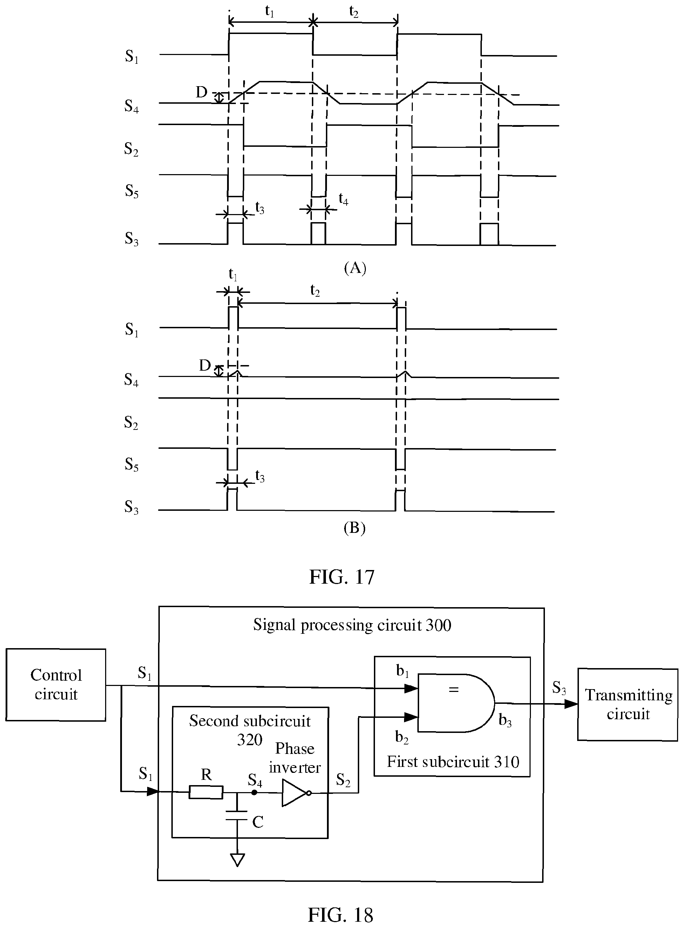

It should be noted that, in the signal processing circuit 300 shown in FIG. 16, the valid level of the third control signal S₃ is the level 1, and the valid level of the first control signal S₁ may be the level 1 or the level 0. Specifically, FIG. 17 is a schematic diagram of an example of a time sequence of each control signal in the foregoing signal processing circuit. In this example, t₁ is a width of one level 1 of the first control signal S₁, t₂ is a width of one level 0 of the first control signal S₁, D is a decision threshold for the phase inverter to determine whether an input level is the level 0 or the level 1, t₃ is a width of a valid level 1 of the third control signal S₃ in one level 1 of the first control signal S₁, and t₄ is a width of one valid level 1 of the third control signal S₃ in one level 0 of the first control signal S₁. (A) in FIG. 17 is a diagram of a time sequence in a case in which the width t₁ of one level 1 and the width t₂ of one level 0 of the first control signal S₁ are large, and (B) in FIG. 17 is a diagram of a time sequence in a case in which the width t₁ of one level 1 of the first control signal S₁ is small.

Refer to FIG. 16 and (A) in FIG. 17. After the level of the first control signal S₁ changes from the level 0 to the level 1, the level 1 is directly output to the first input terminal b₁ of the XOR operation circuit. In addition, the level 1 passes through the RC delay circuit, and charges the capacitor C. In this way, a level of the fourth control signal S₄ output at the second terminal of the resistor R gradually increases from the level 0. In the first t₃ width of the width t₁, although the level of the fourth control signal S₄ increases, the level of the fourth control signal S₄ does not exceed the decision threshold D for the phase inverter to determine the level 0 and the level 1. Therefore, the phase inverter determines that the level of the second control signal S₂ is less than the decision threshold D, that is, considers that the received level is the level 0. In this way, the phase inverter inverts the level 0 to the level 1, and inputs the level 1 to the second input terminal b₂ of the XOR operation circuit. After the XOR operation circuit performs the XOR operation on the first control signal S₁ whose level is 1 and the second control signal S₂ whose level is 1, a level of the fifth control signal S₅ output at the output terminal b₃ of the XOR operation circuit is the level 0. Further, after inversion by the level inversion circuit, a level of the third control signal S₃ output at the output terminal of the level inversion circuit is the level 1. After the first t₃ width of the width t₁, the level of the fourth control signal S₄ increases to exceed the decision threshold D for the phase inverter to determine the level 0 and the level 1. Therefore, the phase inverter determines that the level of the fourth control signal S₄ is greater than the decision threshold D, that is, considers that the received level is the level 1. In this way, the phase inverter inverts the level 1 to the level 0, and inputs the level 0 to the second input terminal b₂ of the XOR operation circuit. After the XOR operation circuit performs the XOR operation on the first control signal S₁ whose level is 1 and the second control signal S₂ whose level is 0, the level of the fifth control signal S₅ output at the output terminal b₃ of the XOR operation circuit is the level 1. Further, after inversion by the level inversion circuit, the level of the third control signal S₃ output at the output terminal of the level inversion circuit is the level 0. Then, after the level of the first control signal S₁ changes from the level 1 to the level 0, the level 0 is directly output to the first input terminal b₁ of the XOR operation circuit. In addition, the level 0 passes through the RC delay circuit, and the capacitor C is discharged, so that the level of the fourth control signal S₄ output at the second terminal of the resistor R gradually decreases from the level 1. In the first t₄ width of the width t₂, although the level of the fourth control signal S₄ decreases, the level of the fourth control signal S₄ is not less than the decision threshold D for the phase inverter to determine the level 0 and the level 1. Therefore, the phase inverter determines that the level of the fourth control signal S₄ is still greater than the decision threshold D, that is, considers that the received level is still the level 1. In this way, the phase inverter inverts the level 1 to the level 0, and inputs the level 0 to the second input terminal b₂ of the XOR operation circuit. After the XOR operation circuit performs the XOR operation on the first control signal S₁ whose level is 0 and the second control signal S₂ whose level is 0, the level of the fifth control signal S₅ output at the output terminal b₃ of the XOR operation circuit is the level 0. Further, after inversion by the level inversion circuit, a level of the third control signal S₃ output at the output terminal of the level inversion circuit is the level 1. After the first t₄ width of the width t₃, the level of the fourth control signal S₄ decreases to be less than the decision threshold D for the phase inverter to determine the level 0 and the level 1. Therefore, the phase inverter determines that the level of the fourth control signal S₄ is less than the decision threshold D, that is, considers that the received level changes to the level 0. In this way, the phase inverter inverts the level 0 to the level 1, and inputs the level 1 to the second input terminal b₂ of the XOR operation circuit. After the XOR operation circuit performs the XOR operation on the first control signal S₁ whose level is 0 and the second control signal S₂ whose level is 1, the level of the fifth control signal S₅ output at the output terminal b₃ of the XOR operation circuit is the level 1. Further, after inversion by the level inversion circuit, the level of the third control signal S₃ output at the output terminal of the level inversion circuit is the level 0. It can be learned that, when both the width t₁ of one level 1 of the first control signal S₁ and the width t₂ of one level 0 of the first control signal S₁ are large, the signal processing circuit shown in FIG. 16 can not only generate a valid level 1 with the width t₃ in the width t₁ of one level 1 of the first control signal S₁, but also generate a valid level 1 with the width of t₄ in the width t₂ of one level 0 of the first control signal S₁. That is, the third control signal S₃ having two narrow widths can be generated in a width of one level 1 and one level 0 of the first control signal.

Refer to FIG. 16 and (B) in FIG. 17. After the level of the first control signal S₁ changes from the level 0 to the level 1, the level 1 is directly input to the first input terminal b₁ of the XOR operation circuit. In addition, the level 1 passes through the RC delay circuit, and charges the capacitor C. In this way, a level of the fourth control signal S₄ output at the second terminal of the resistor R gradually increases from the level 0. In the entire width t₁, although the level of the fourth control signal S₄ continuously increases, the level of the fourth control signal S₄ does not exceed the decision threshold D for the phase inverter to determine the level 0 and the level 1. Therefore, the phase inverter determines that the level of the fourth control signal S₄ is always less than the decision threshold D, that is, considers that the level of the received fourth control signal S₄ is always the level 0. In this way, the phase inverter inverts the level 0 to the level 1, and inputs the level 1 to the second input terminal b₂ of the XOR operation circuit. After the XOR operation circuit performs the XOR operation on the first control signal S₁ whose level is the level 1 and the second control signal S₂ whose level is the level 1, a level of the fifth control signal S₅ output at the output terminal b₃ of the XOR operation circuit is always the level 0. Further, after inversion by the level inversion circuit, a level of the third control signal S₃ output at the output terminal of the level inversion circuit is always the level 1. Then, after the level of the first control signal S₁ changes from the level 1 to the level 0, the level 0 is directly input to the first input terminal b₁ of the XOR operation circuit. In addition, the level 0 passes through the RC delay circuit, and the capacitor C is discharged, so that the level of the fourth control signal S₄ output at the second terminal of the resistor R gradually decreases. In an entire width of the level 0, although the level of the fourth control signal S₄ continuously decreases, the level of the fourth control signal S₄ is always less than the decision threshold D for the phase inverter to determine the level 0 and the level 1. Therefore, the phase inverter determines that the level of the fourth control signal S₄ is always less than the decision threshold D, that is, considers that the level of the received fourth control signal S₄ is always the level 0. In this way, the phase inverter inverts the level 0 to the level 1, and inputs the level 1 to the second input terminal b₂ of the XOR operation circuit. After the XOR operation circuit performs the XOR operation on the first control signal S₁ whose level is the level 0 and the second control signal S₂ whose level is the level 1, a level of the fifth control signal S₅ output at the output terminal b₃ of the XOR operation circuit is always the level 1. Further, after inversion by the level inversion circuit, a level of the third control signal S₃ output at the output terminal of the level inversion circuit is always the level 0. It can be learned that, when the width t₁ of the valid level 1 of the first control signal S₁ is small, the signal processing circuit shown in FIG. 16 can further output the third control signal S₃, to flexibly adjust, as the first control signal S₁ changes, duration of transmitting the laser signal by the transmitting circuit, where the width t₃ of the valid level 1 of the third control signal S₃ is equal to t₁.

It should be noted that the signal processing circuit 5 may alternatively change, by using the control circuit, a decision threshold and/or a time constant that are/is used by the phase inverter to determine the level 0 and the level 1, to flexibly adjust the width of the valid level of the third control signal S₃. For a specific implementation operation, refer to the descriptions of the foregoing signal processing circuit 1. Details are not described in embodiments of this application again.

### Signal processing circuit 6

FIG. 18 is a schematic diagram of an example of a structure of still another signal processing circuit according to Embodiment 2 of this application. As shown in FIG. 18, in this example, the first subcircuit 310 includes an XNOR operation circuit (namely, a device with an XNOR operation symbol "=" in FIG. 18), and the second subcircuit 320 includes a resistor R, a capacitor C, and a phase inverter. Both a first input terminal b₁ of the XNOR operation circuit and a first terminal of the resistor R are configured to receive the first control signal S₁, a second terminal of the resistor R is connected to both a first terminal of the capacitor C and an input terminal of the phase inverter, a second terminal of the capacitor C is grounded, an output terminal of the phase inverter is connected to a second input terminal b₂ of the XNOR operation circuit, and an output terminal b₃ of the XNOR operation circuit is configured to output the third control signal S₃. The first control signal S₁ output by the control circuit is directly input to the first input terminal b₁ of the XNOR operation circuit, and is delayed by an RC circuit, and a fourth control signal S₄ is output at the second terminal of the resistor R. After the phase inverter converts the fourth control signal S₄ into the second control signal S₂, the second control signal S₂ is transmitted to the second input terminal b₂ of the XNOR operation circuit. After the XNOR operation circuit performs an XNOR operation on the first control signal S₁ received by the first input terminal b₁ and the second control signal S₂ received by the second input terminal b₂, the third control signal S₃ is output at the output terminal b₃ of the XNOR operation circuit.

It should be noted that, in the signal processing circuit 6, the valid level of the third control signal S₃ is the level 1, and the valid level of the first control signal S₁ may be the level 1 or the level 0. For a diagram of a time sequence of each node in the signal processing circuit 6, refer to the descriptions of the foregoing signal processing circuit 9. A difference lies in: In the signal processing circuit 5, the XOR operation is first performed on the first control signal S₁ and the second control signal S₂ to obtain the fifth control signal S₅ whose level is opposite to the level of the third control signal S₃, and then level reversion is performed to obtain the third control signal S₃. Instead, in the signal processing circuit 6, the XNOR operation circuit directly performs the XNOR operation on the first control signal S₁ input at the first input terminal b₁ and the second control signal S₂ input at the second input terminal b₂, to directly output the third control signal S₃ at the output terminal b₃ of the signal processing circuit 6. In addition, the signal processing circuit 6 may alternatively perform power driving on the third control signal S₃. A power drive circuit may be synchronously implemented in the XNOR operational circuit, or may be implemented by adding an additional power drive circuit. For the power drive circuit, refer to the descriptions of the foregoing signal processing circuit 2. Details are not described in embodiments of this application again. In addition, the signal processing circuit 6 may alternatively change, by using the control circuit, a decision threshold and/or a time constant that are/is used by the phase inverter to determine the level 0 and the level 1, to flexibly adjust the width of the valid level of the third control signal S₃. For a specific implementation operation, refer to the descriptions of the foregoing signal processing circuit 1. Details are not described in embodiments of this application again.

### [Embodiment 2]: A second subcircuit includes a resistor R and a capacitor C.

### Signal processing circuit 7

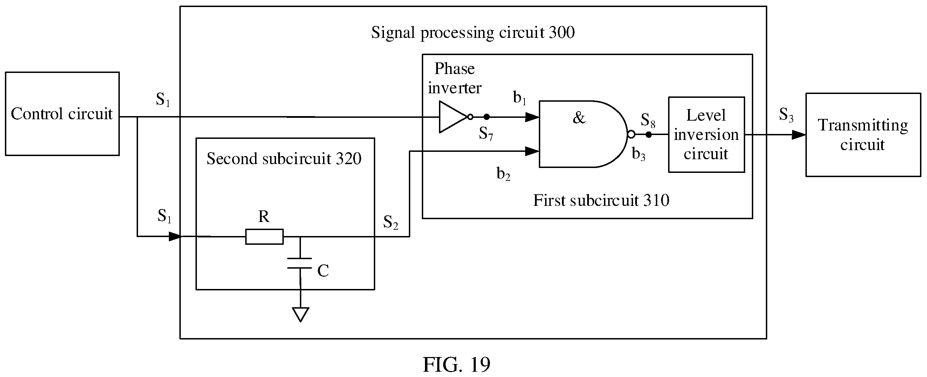

FIG. 19 is a schematic diagram of an example of a structure of a signal processing circuit according to Embodiment 2 of this application. In this example, the valid level of the first control signal S₁ is a level 0, and the valid level of the third control signal S₃ is a level 1. As shown in FIG. 19, in this example, the first subcircuit 310 includes a phase inverter, a NAND operation circuit (namely, a device with an AND operator "&" and a NOT operator " ∘ " in FIG. 19), and a level inversion circuit, and the second subcircuit 320 includes a resistor R and a capacitor C. Both an input terminal of the phase inverter and a first terminal of the resistor R are configured to receive the first control signal S₁, an output terminal of the phase inverter is connected to a first input terminal b₁ of the NAND operation circuit, a second terminal of the resistor R is connected to both a first terminal of the capacitor C and a second input terminal b₂ of the NAND operation circuit, a second terminal of the capacitor C is grounded, an output terminal b₃ of the NAND operation circuit is connected to an input terminal of a level inversion circuit, and an output terminal of the level inversion circuit is configured to output the third control signal S₃. The first control signal S₁ output by the control circuit is transmitted to the phase inverter, and is inverted to a seventh control signal S₇ by the phase inverter, and then the seventh control signal S₇ is input to the first input terminal b₁ of the NAND operation circuit. In addition, the first control signal S₁ is transmitted to the resistor R. After the first control signal S₁ is delayed by an RC circuit, the second control signal S₂ is output at the second terminal of the resistor R, and then the second control signal S₂ is transmitted to the second input terminal b₂ of the NAND operation circuit. After the NAND operation circuit performs a NAND operation on the seventh control signal S₇ received by the first input terminal b₁ and the second control signal S₂ received by the second input terminal b₂, an eighth control signal S₈ is output at the output terminal b₃ of the NAND operation circuit. After level inversion by the level inversion circuit, the third control signal S₃ is output at the output terminal of the level inversion circuit.

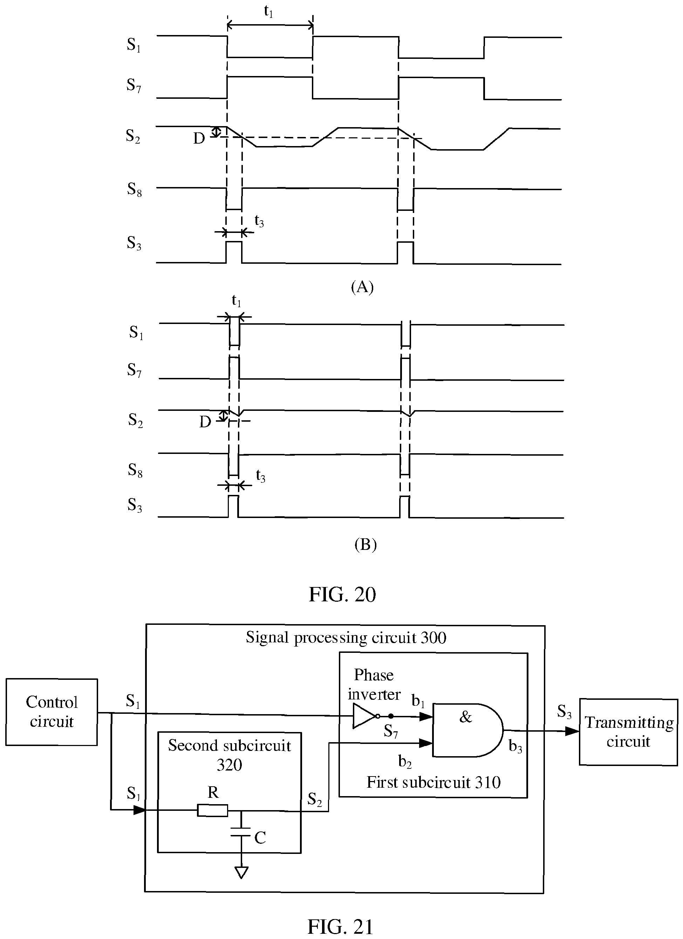

FIG. 20 is a schematic diagram of an example of a time sequence of each control signal in the foregoing signal processing circuit. In this example, t₁ is a width of one valid level 0 of the first control signal S₁, D is a decision threshold (whose implementation principle is the same as that of the decision threshold D in the foregoing inverter) for the NAND operation circuit to determine that an input level is the level 0 or the level 1, and t₃ is a width of one valid level 1 of the third control signal S₃. (A) in FIG. 20 is a diagram of a time sequence in a case in which the width t₁ of one valid level 0 of the first control signal S₁ is large, and (B) in FIG. 20 is a diagram of a time sequence in a case in which the width t₁ of one valid level 0 of the first control signal S₁ is small.

Refer to FIG. 19 and (A) in FIG. 20. After the level of the first control signal S₁ changes from the level 1 to the level 0, the level 0 is input to the phase inverter, and after the phase inverter performs phase inversion on the level 0, the seventh control signal S₇ whose level is 1 is output at the output terminal of the phase inverter to the first input terminal b₁ of the NAND operation circuit. In addition, the level 0 passes through the RC delay circuit, and the capacitor C is discharged, so that the level of the second control signal S₂ output at the second terminal of the resistor R gradually decreases from the level 1. In the first t₃ width of the width t₁, although the level of the second control signal S₂ decreases, the level of the second control signal S₂ is not less than the decision threshold D for the NAND operation circuit to determine the level 0 and the level 1. Therefore, the NAND operation circuit determines that the level of the second control signal S₂ is not less than the decision threshold D, that is, considers that the input level is the level 1. In this way, after the NAND operation circuit performs the NAND operation on the seventh control signal S₇ whose level is 1 and the second control signal S₂ whose level is 1, a level of the eighth control signal S₈ output at the output terminal b₃ of the NAND operation circuit is the level 0. Further, after level inversion by the level inversion circuit, a level of the third control signal S₃ output at the output terminal of the level inversion circuit is the level 1. After the first t₃ width of the width t₁, the level of the second control signal S₂ decreases to be less than the decision threshold D for the NAND operation circuit to determine the level 0 and the level 1. The NAND operation circuit determines that the level of the second control signal S₂ is less than the decision threshold D, that is, considers that the input level is the level 0. Therefore, after the NAND operation circuit performs the NAND operation on the seventh control signal S₇ whose level is 1 and the second control signal S₂ whose level is 0, the level of the eighth control signal S₈ output at the output terminal b₃ of the NAND operation circuit is the level 1. Further, after level inversion by the level inversion circuit, the level of the third control signal S₃ output at the output terminal of the level inversion circuit is the level 0. Then, after the level of the first control signal S₁ changes from the level 0 to the level 1, the level 1 is inverted by the phase inverter, and the seventh control signal S₇ with the level 0 is output at the output terminal of the phase inverter to the first input terminal b₁ of the NAND operation circuit. In addition, the level 1 passes through the RC delay circuit, and charges the capacitor C. In this way, the level of the second control signal S₂ output at the second terminal of the resistor R gradually increases from the level 0. That is, the level of the second control signal S₂ is first considered as the level 1 by the NAND operation circuit and then considered as the level 0 by the NAND operation circuit. However, regardless of a state of the level of the second control signal S₂, after the NAND operation circuit performs the NAND operation on the seventh control signal S₇ whose level is the level 0 and the second control signal S₂ in any level state, the level of the eighth control signal S₈ output at the output terminal b₃ of the NAND operation circuit is the level 1. Further, after level inversion by the level inversion circuit, the level of the third control signal S₃ output by the level inversion circuit is always the level 0. It can be learned that, when the width t₁ of the valid level 0 of the first control signal S₁ is large, the signal processing circuit shown in FIG. 19 can output the third control signal S₃, where the width t₃ of the valid level 1 of the third control signal S₃ is less than t₁. This effectively limits transmission duration of the transmitting circuit.

Refer to FIG. 19 and (B) in FIG. 20. After the level of the first control signal S₁ changes from the level 1 to the level 0, the level 0 is inverted by the phase inverter, and the seventh control signal S₇ whose level is 1 is output at the output terminal of the phase inverter to the first input terminal b₁ of the NAND operation circuit. In addition, the level 0 passes through the RC delay circuit, and the capacitor C is discharged, so that the level of the second control signal S₂ output at the second terminal of the resistor R gradually decreases from the level 1. In the entire width t₁, although the level of the second control signal S₂ continuously decreases, the level of the second control signal S₂ is not less than the decision threshold D for the NAND operation circuit to determine the level 0 and the level 1. Therefore, the NAND operation circuit determines that the level input by the second input terminal b₂ is always not less than the decision threshold D, that is, considers that the level of the second control signal S₂ received by the second input terminal b₂ is always the level 1. In this way, after the NAND operation circuit performs the NAND operation on the seventh control signal S₇ whose level is 1 and the second control signal S₂ whose level is 1, the level of the eighth control signal S₈ output at the output terminal b₃ of the NAND operation circuit is always the level 0. Further, after level inversion by the level inversion circuit, the level of the third control signal S₃ output at the output terminal of the level inversion circuit is always the level 1. Then, after the level of the first control signal S₁ changes from the level 0 to the level 1, the level 1 is inverted by the phase inverter, and the seventh control signal S₇ with the level 0 is output at the output terminal of the phase inverter to the first input terminal b₁ of the NAND operation circuit. Therefore, regardless of the state of the level of the second control signal S₂, after the NAND operation circuit performs the NAND operation on the seventh control signal S₇ whose level is 0 and the second control signal S₂ in any level state, the level of the eighth control signal S₈ output at the output terminal b₃ of the NAND operation circuit is always the level 1. Further, after inversion by the level inversion circuit, the level of the third control signal S₃ output at the output terminal of the level inversion circuit is always the level 0. It can be learned that, when the width t₁ of the valid level 0 of the first control signal S₁ is small, the signal processing circuit shown in FIG. 19 can further output the third control signal S₃, to flexibly adjust, as the first control signal S₁ changes, duration of transmitting the laser signal by the transmitting circuit, where the width t₃ of the valid level 1 of the third control signal S₃ is equal to t₁.

It should be noted that the signal processing circuit 7 may alternatively change, by using the control circuit, a decision threshold and/or a time constant that are/is used by the NAND operation circuit to determine the level 1 and the level 1, to flexibly adjust the width of the valid level of the third control signal S₃. For a specific implementation operation, refer to the descriptions of the foregoing signal processing circuit 1. Details are not described in embodiments of this application again.

### Signal processing circuit 8

FIG. 21 is a schematic diagram of an example of a structure of another signal processing circuit according to Embodiment 2 of this application. In this example, the valid level of the first control signal S₁ is a level 0, and the valid level of the third control signal S₃ is a level 1. As shown in FIG. 21, in this example, the first subcircuit 310 includes a phase inverter and an AND operation circuit (namely, a device with an AND operation symbol "&" in FIG. 21), and the second subcircuit 320 includes a resistor R and a capacitor C. Both an input terminal of the phase inverter and a first terminal of the resistor R are configured to receive the first control signal S₁, an output terminal of the phase inverter is connected to a first input terminal b₁ of the AND operation circuit, a second terminal of the resistor R is connected to both a first terminal of the capacitor C and a second input terminal b₂ of the AND operation circuit, a second terminal of the capacitor C is grounded, and an output terminal b₃ of the AND operation circuit is configured to output the third control signal S₃. After the control circuit outputs the first control signal S₁, the first control signal S₁ is inverted to a seventh control signal S₇ by the phase inverter, and then the seventh control signal S₇ is input to the first input terminal b₁ of the AND operation circuit. In addition, after the first control signal S₁ is delayed by an RC circuit, the second control signal S₂ is output at the second terminal of the resistor R, and then the second control signal S₂ is transmitted to the second input terminal b₂ of the AND operation circuit. After the AND operation circuit performs an AND operation on the seventh control signal S₇ received by the first input terminal b₁ and the second control signal S₂ received by the second input terminal b₂, the third control signal S₃ is directly output at the output terminal b₃ of the AND operation circuit.

It should be noted that, for a diagram of a time sequence of each node in the signal processing circuit 8, refer to the foregoing signal processing circuit 7. A difference lies in: In the signal processing circuit 7, the NAND operation is first performed on the seventh control signal S₇ and the second control signal S₂ to obtain the eighth control signal S₈ whose level is opposite to the level of the third control signal S₃, and then the level inversion circuit performs level reversion to obtain the third control signal S₃. Instead, in the signal processing circuit 8, the AND operation circuit directly performs the AND operation on the seventh control signal S₇ input at the first input terminal b₁ and the second control signal S₂ input at the second input terminal b₂, to directly output the third control signal S₃ at the output terminal b₃. In addition, the signal processing circuit 8 may alternatively perform power driving on the third control signal S₃. A power drive circuit may be synchronously implemented in the AND operational circuit, or may be implemented by adding an additional power drive circuit. For the power drive circuit, refer to the descriptions of the foregoing signal processing circuit 2. Details are not described in embodiments of this application again. In addition, the signal processing circuit 8 may alternatively change, by using the control circuit, a decision threshold and/or a time constant that are/is used by the AND operational circuit to determine the level 0 and the level 1, to flexibly adjust the width of the valid level of the third control signal S₃. For a specific implementation operation, refer to the descriptions of the foregoing signal processing circuit 1. Details are not described in embodiments of this application again.

### Signal processing circuit 9

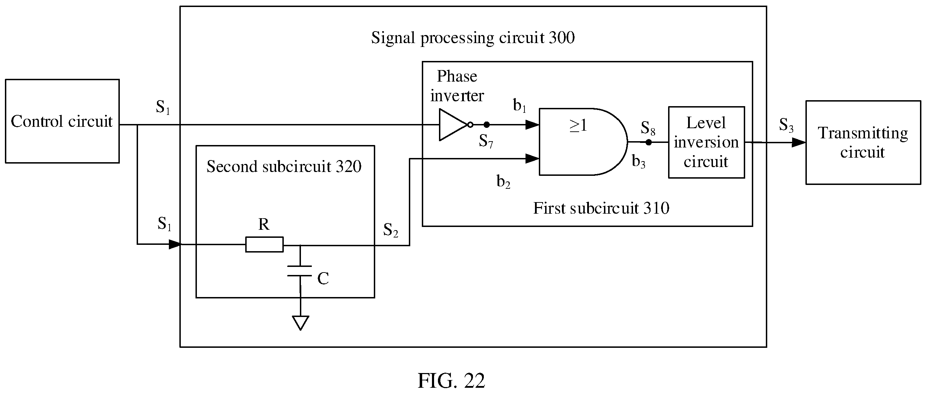

FIG. 22 is a schematic diagram of an example of a structure of still another signal processing circuit according to Embodiment 2 of this application. In this example, each of the valid level of the first control signal S₁ and the valid level of the third control signal S₃ is a level 1. As shown in FIG. 22, in this example, the first subcircuit 310 includes a phase inverter, an OR operation circuit (namely, a device with an OR operation symbol "≥1" in FIG. 22) and a level inversion circuit, and the second subcircuit 320 includes a resistor R and a capacitor C. Both an input terminal of the phase inverter and a first terminal of the resistor R are configured to receive the first control signal S₁, an output terminal of the phase inverter is connected to a first input terminal b₁ of the OR operation circuit, a second terminal of the resistor R is connected to both a first terminal of the capacitor C and a second input terminal b₂ of the OR operation circuit, a second terminal of the capacitor C is grounded, an output terminal b₃ of the OR operation circuit is connected to an input terminal of a level inversion circuit, and an output terminal of the level inversion circuit is configured to output the third control signal S₃. The first control signal S₁ output by the control circuit is inverted to a seventh control signal S₇ by the phase inverter, and then the seventh control signal S₇ is input to the first input terminal b₁ of the OR operation circuit. In addition, after the first control signal S₁ is delayed by an RC circuit, the second control signal S₂ is output at the second terminal of the resistor R, and then the second control signal S₂ is transmitted to the second input terminal b₂ of the OR operation circuit. After the OR operation circuit performs an OR operation on the seventh control signal S₇ received by the first input terminal b₁ and the second control signal S₂ received by the second input terminal b₂, an eighth control signal S₈ is output at the output terminal b₃ of the OR operation circuit. After level inversion by the level inversion circuit, the third control signal S₃ is output at the output terminal of the level inversion circuit.

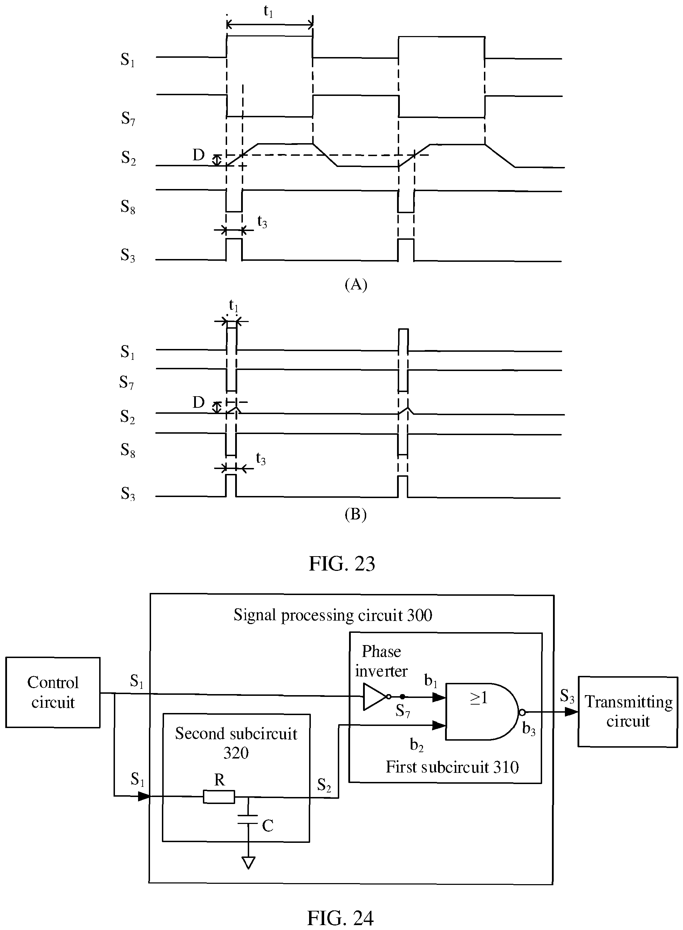

FIG. 23 is a schematic diagram of an example of a time sequence of each control signal in the foregoing signal processing circuit. In this example, t₁ is a width of one valid level 1 of the first control signal S₁, D is a decision threshold for the OR operation circuit to determine that an input level is the level 0 or the level 1, and t₃ is a width of one valid level 1 of the third control signal S₃. (A) in FIG. 23 is a diagram of a time sequence in a case in which the width t₁ of one level 1 of the first control signal S₁ is large, and (B) in FIG. 23 is a diagram of a time sequence in a case in which the width t₁ of one level 1 of the first control signal S₁ is small.

Refer to FIG. 22 and (A) in FIG. 23. After the level of the first control signal S₁ changes from the level 0 to the level 1, the level 1 is inverted by the phase inverter, and the seventh control signal S₇ whose level is 0 is output at the output terminal of the phase inverter to the first input terminal b₁ of the OR operation circuit. In addition, the level 1 passes through the RC delay circuit, and charges the capacitor C. In this way, the level of the second control signal S₂ output at the second terminal of the resistor R gradually increases from the level 0. In the first t₃ width of the width t₁, although the level of the second control signal S₂ increases, the level of the second control signal S₂ does not exceed the decision threshold D for the OR operation circuit to determine the level 0 and the level 1. Therefore, the OR operation circuit determines that the level of the second control signal S₂ is less than the decision threshold D, that is, considers that the level received by the second input terminal b₁ is the level 0. In this way, after the OR operation circuit performs the OR operation on the seventh control signal S₇ whose level is 0 and the second control signal S₂ whose level is 0, a level of the eighth control signal S₈ output at the output terminal b₃ of the OR operation circuit is the level 0. Further, after level inversion by the level inversion circuit, a level of the third control signal S₃ output at the output terminal of the level inversion circuit is the level 1. After the first t₃ width of the width t₁, the level of the second control signal S₂ increases to exceed the decision threshold D for the OR operation circuit to determine the level 0 and the level 1. The OR operation circuit determines that the level of the second control signal S₂ is not less than the decision threshold D, that is, considers that the level received by the second input terminal b₁ is the level 1. Therefore, after the OR operation circuit performs the OR operation on the seventh control signal S₇ whose level is the level 0 and the second control signal S₂ whose level is the level 1, the level of the eighth control signal S₈ output at the output terminal b₃ of the OR operation circuit is the level 1. Further, after level inversion by the level inversion circuit, the level of the third control signal S₃ output at the output terminal of the level inversion circuit is the level 0. Then, after the level of the first control signal S₁ changes from the level 1 to the level 0, the level 0 is inverted by the phase inverter, and the seventh control signal S₇ with the level 1 is output at the output terminal of the phase inverter to the first input terminal b₁ of the OR operation circuit. Therefore, regardless of a state of the level of the second control signal S₂, after the OR operation circuit performs the OR operation on the seventh control signal S₇ whose level is the level 1 and the second control signal S₂ with any level, the level of the eighth control signal S₈ output at the output terminal b₃ of the OR operation circuit is the level 1. Further, after inversion by the level inversion circuit, the level of the third control signal S₃ output at the output terminal of the level inversion circuit is always the level 0. It can be learned that, when the width t₁ of the valid level 1 of the first control signal S₁ is large, the signal processing circuit shown in FIG. 22 can output the third control signal S₃, where the width t₃ of the valid level 1 of the third control signal S₃ is less than t₁. This effectively limits transmission duration of the transmitting circuit.

Refer to FIG. 22 and (B) in FIG. 23. After the level of the first control signal S₁ changes from the level 0 to the level 1, the level 1 is inverted by the phase inverter, and the seventh control signal S₇ whose level is 0 is output at the output terminal of the phase inverter to the first input terminal b₁ of the OR operation circuit. In addition, the level 1 passes through the RC delay circuit, and charges the capacitor C. In this way, the level of the second control signal S₂ output at the second terminal of the resistor R gradually increases from the level 0. In the entire width t₁, although the level of the second control signal S₂ continuously increases, the level of the second control signal S₂ does not exceed the decision threshold D for the OR operation circuit to determine the level 0 and the level 1. Therefore, the OR operation circuit determines that the level input by the second input terminal b₂ is always less than the decision threshold D, that is, considers that the level of the second control signal S₂ received by the second input terminal b₂ is always the level 0. In this way, after the OR operation circuit performs the OR operation on the seventh control signal S₇ whose level is the level 0 and the second control signal S₂ whose level is the level 0, the level of the eighth control signal S₈ output at the output terminal b₃ of the OR operation circuit is always the level 0. Further, after level inversion by the level inversion circuit, the level of the third control signal S₃ output at the output terminal of the level inversion circuit is always the level 1. Then, after the level of the first control signal S₁ changes from the level 1 to the level 0, the level 0 is inverted by the phase inverter, and the seventh control signal S₇ with the level 1 is output at the output terminal of the phase inverter to the first input terminal b₁ of the OR operation circuit. Therefore, regardless of a state of the level of the second control signal S₂, after the OR operation circuit performs the OR operation on the seventh control signal S₇ whose level is the level 1 and the second control signal S₂ with any level, the level of the eighth control signal S₈ output at the output terminal b₃ of the OR operation circuit is the level 1. Further, after inversion by the level inversion circuit, the level of the third control signal S₃ output at the output terminal of the level inversion circuit is always the level 0. It can be learned that, when the width t₁ of the valid level 0 of the first control signal S₁ is small, the signal processing circuit shown in FIG. 22 can further output the third control signal S₃, to flexibly adjust, as the first control signal S₁ changes, duration of transmitting the laser signal by the transmitting circuit, where the width t₃ of the valid level 1 of the third control signal S₃ is equal to t₁.

It should be noted that the signal processing circuit 9 may alternatively change, by using the control circuit, a decision threshold and/or a time constant that are/is used by the OR operation circuit to determine the level 0 and the level 1, to flexibly adjust the width of the valid level of the third control signal S₃. For a specific implementation operation, refer to the descriptions of the foregoing signal processing circuit 1. Details are not described in embodiments of this application again.

### Signal processing circuit 10

FIG. 24 is a schematic diagram of an example of a structure of still another signal processing circuit according to Embodiment 2 of this application. In this example, each of the valid level of the first control signal S₁ and the valid level of the third control signal S₃ is a level 1. As shown in FIG. 24, in this example, the first subcircuit 310 includes a phase inverter and a NOR operation circuit (namely, a device with an OR operator "≥1" and a NOT operator " ∘ " in FIG. 24), and the second subcircuit 320 includes a resistor R and a capacitor C. Both an input terminal of the phase inverter and a first terminal of the resistor R are configured to receive the first control signal S₁, an output terminal of the phase inverter is connected to a first input terminal b₁ of the NOR operation circuit, a second terminal of the resistor R is connected to both a first terminal of the capacitor C and a second input terminal b₂ of the NOR operation circuit, a second terminal of the capacitor C is grounded, and an output terminal b₃ of the NOR operation circuit is configured to output the third control signal S₃. After the first control signal S₁ output by the control circuit is inverted to a seventh control signal S₇ by the phase inverter, the seventh control signal S₇ is input to the first input terminal b₁ of the NOR operation circuit. In addition, after the first control signal S₁ is delayed by an RC circuit, the second control signal S₂ is output at the second terminal of the resistor R, and then the second control signal S₂ is transmitted to the second input terminal b₂ of the NOR operation circuit. After the NOR operation circuit performs a NOR operation on the seventh control signal S₇ received by the first input terminal b₁ and the second control signal S₂ received by the second input terminal b₂, the third control signal S₃ is output at the output terminal b₃ of the NOR operation circuit.

It should be noted that, for a diagram of a time sequence of each node in the signal processing circuit 10, refer to the foregoing signal processing circuit 9. A difference lies in: In the signal processing circuit 9, the OR operation is first performed on the seventh control signal S₇ and the second control signal S₂ to obtain the eighth control signal S₈ whose level is opposite to the level of the third control signal S₃, and then level inversion is performed to obtain the third control signal S₃. Instead, in the signal processing circuit 10, the NOR operation circuit directly performs the NOR operation on the seventh control signal S₇ input at the first input terminal b₁ and the second control signal S₂ input at the second input terminal b₂, to directly output the third control signal S₃ at the output terminal b₃ of the signal processing circuit 10. In addition, the signal processing circuit 10 may alternatively perform power driving on the third control signal S₃. A power drive circuit may be synchronously implemented in the NOR operational circuit, or may be implemented by adding an additional power drive circuit. For the power drive circuit, refer to the descriptions of the foregoing signal processing circuit 2. Details are not described in embodiments of this application again. In addition, the signal processing circuit 10 may alternatively change, by using the control circuit, a decision threshold and/or a time constant that are/is used by the NOR operational circuit to determine the level 0 and the level 1, to flexibly adjust the width of the valid level of the third control signal S₃. For a specific implementation operation, refer to the descriptions of the foregoing signal processing circuit 1. Details are not described in embodiments of this application again.

### Signal processing circuit 11

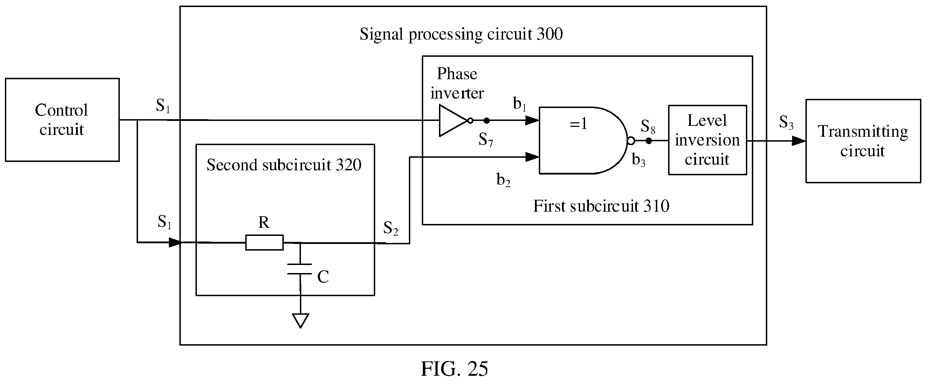

FIG. 25 is a schematic diagram of an example of a structure of still another signal processing circuit according to Embodiment 2 of this application. As shown in FIG. 25, in this example, the first subcircuit 310 includes a phase inverter, an XOR operation circuit (namely, a device with an XOR operation symbol "=1" in FIG. 25), and a level inversion circuit, and the second subcircuit 320 includes a resistor R and a capacitor C. Both an input terminal of the phase inverter and a first terminal of the resistor R are configured to receive the first control signal S₁, an output terminal of the phase inverter is connected to a first input terminal b₁ of the XOR operation circuit, a second terminal of the resistor R is connected to both a first terminal of the capacitor C and a second input terminal b₂ of the XOR operation circuit, a second terminal of the capacitor C is grounded, an output terminal b₃ of the XOR operation circuit is connected to an input terminal of a level inversion circuit, and an output terminal of the level inversion circuit is configured to output the third control signal S₃. The first control signal S₁ output by the control circuit is inverted to a seventh control signal S₇ by the phase inverter, and then the seventh control signal S₇ is input to the first input terminal b₁ of the XOR operation circuit. In addition, after the first control signal S₁ is delayed by an RC circuit, the second control signal S₂ is output at the second terminal of the resistor R, and then the second control signal S₂ is transmitted to the second input terminal b₂ of the XOR operation circuit. After the XOR operation circuit performs an XOR operation on the first control signal S₁ received by the first input terminal b₁ and the second control signal S₂ received by the second input terminal b₂, an eighth control signal S₈ is output at the output terminal b₃ of the XOR operation circuit. After level inversion by the level inversion circuit, the third control signal S₃ is output at the output terminal of the level inversion circuit.

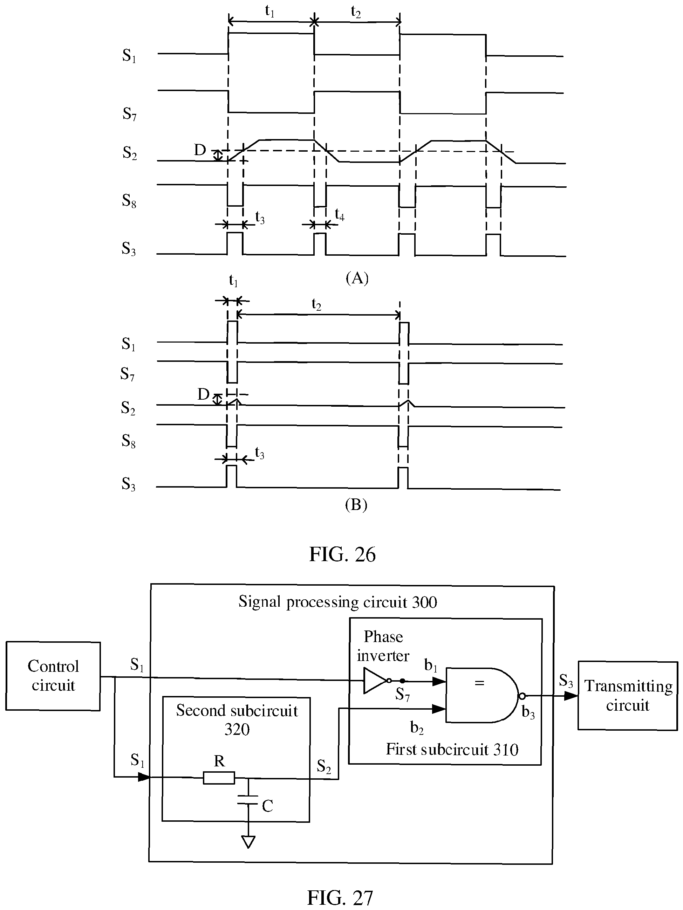

It should be noted that, in the signal processing circuit 11, the valid level of the third control signal S₃ is the level 1, and the valid level of the first control signal S₁ may be the level 1 or the level 0. For example, FIG. 26 is a schematic diagram of an example of a time sequence of each control signal in the foregoing signal processing circuit. In this example, t₁ is a width of one level 1 of the first control signal S₁, t₂ is a width of one level 0 of the first control signal S₁, D is a decision threshold for the XOR operation circuit to determine whether an input level is the level 0 or the level 1, t₃ is a width of one valid level 1 of the third control signal S₃ in the width t₁ of one level 1 of the first control signal S₁, and t₄ is a width of one valid level 1 of the third control signal S₃ in the width t₂ of one level 0 of the first control signal S₁. (A) in FIG. 26 is a diagram of a time sequence in a case in which the width t₁ of one level 1 and the width t₂ of one level 0 of the first control signal S₁ are large, and (B) in FIG. 26 is a diagram of a time sequence in a case in which the width t₁ of one level 1 of the first control signal S₁ is small.

Refer to FIG. 25 and (A) in FIG. 26. After the level of the first control signal S₁ changes from the level 0 to the level 1, the level 1 is inverted by the phase inverter, and the seventh control signal S₇ whose level is 0 is output at the output terminal of the phase inverter to the first input terminal b₁ of the OR operation circuit. In addition, the level 1 passes through the RC delay circuit, and charges the capacitor C. In this way, the level of the second control signal S₂ output at the second terminal of the resistor R gradually increases from the level 0. In the first t₃ width of the width t₁, although the level of the second control signal S₂ increases, the level of the second control signal S₂ does not exceed the decision threshold D for the XOR operation circuit to determine the level 0 and the level 1. Therefore, the XOR operation circuit determines that the level of the second control signal S₂ is less than the decision threshold D, that is, considers that the level received by the second input terminal b₁ is the level 0. In this way, after the XOR operation circuit performs the XOR operation on the seventh control signal S₇ whose level is 0 and the second control signal S₂ whose level is 0, a level of the eighth control signal S₈ output at the output terminal b₃ of the XOR operation circuit is the level 0. Further, after level inversion by the level inversion circuit, a level of the third control signal S₃ output at the output terminal of the level inversion circuit is the level 1. After the first t₃ width of the width t₁, the level of the second control signal S₂ increases to exceed the decision threshold D for the XOR operation circuit to determine the level 0 and the level 1. The XOR operation circuit determines that the level of the second control signal S₂ is not less than the decision threshold D, that is, considers that the level received by the second input terminal b₁ is the level 1. Therefore, after the XOR operation circuit performs the XOR operation on the seventh control signal S₇ whose level is the level 0 and the second control signal S₂ whose level is the level 1, the level of the eighth control signal S₈ output at the output terminal b₃ of the XOR operation circuit is the level 1. Further, after level inversion by the level inversion circuit, the level of the third control signal S₃ output at the output terminal of the level inversion circuit is the level 0. Then, after the level of the first control signal S₁ changes from the level 1 to the level 0, the level 0 is inverted by the phase inverter, and the seventh control signal S₇ whose level is 1 is output at the output terminal of the phase inverter to the first input terminal b₁ of the XOR operation circuit. In addition, the level 0 passes through the RC delay circuit, and the capacitor C is discharged, so that the level of the second control signal S₂ output at the second terminal of the resistor R gradually decreases from the level 1. In the first t₄ width of the width t₂, although the level of the second control signal S₂ decreases, the level of the second control signal S₂ is not less than the decision threshold D for the XOR operation circuit to determine the level 0 and the level 1. Therefore, the XOR operation circuit determines that the level of the second control signal S₂ is still greater than the decision threshold D, that is, considers that the level received by the second input terminal b₁ is still the level 1. In this way, after the XOR operation circuit performs the XOR operation on the seventh control signal S₇ whose level is 1 and the second control signal S₂ whose level is 1, a level of the eighth control signal S₈ output at the output terminal b₃ of the XOR operation circuit is the level 0. Further, after level inversion by the level inversion circuit, the level of the third control signal S₃ output at the output terminal of the level inversion circuit is the level 1. After the first t₄ width of the width t₃, the level of the second control signal S₂ decreases to be less than the decision threshold D for the XOR operation circuit to determine the level 0 and the level 1. The XOR operation circuit determines that the level of the second control signal S₂ is less than the decision threshold D, that is, considers that the level received by the second input terminal b₁ changes to the level 0. Therefore, after the XOR operation circuit performs the XOR operation on the seventh control signal S₇ whose level is the level 1 and the second control signal S₂ whose level is the level 0, the level of the eighth control signal S₈ output at the output terminal b₃ of the XOR operation circuit is the level 1. Further, after level inversion by the level inversion circuit, the level of the third control signal S₃ output at the output terminal of the level inversion circuit is the level 0. It can be learned that, when both the width t₁ of one level 1 of the first control signal S₁ and the width t₂ of one level 0 of the first control signal S₁ are large, the signal processing circuit shown in FIG. 25 can not only generate a valid level 1 with the width t₃ in the width t₁ of one level 1 of the first control signal S₁, but also generate a valid level 1 with the width of t₄ in the width t₂ of one level 0 of the first control signal S₁. That is, the third control signal S₃ having two narrow widths are generated in a width of one level 1 and one level 0 of the first control signal.

Refer to FIG. 25 and (B) in FIG. 26. After the level of the first control signal S₁ changes from the level 0 to the level 1, the level 1 is inverted by the phase inverter, and the seventh control signal S₇ whose level is 0 is output at the output terminal of the phase inverter to the first input terminal b₁ of the OR operation circuit. In addition, the level 1 passes through the RC delay circuit, and charges the capacitor C. In this way, the level of the second control signal S₂ output at the second terminal of the resistor R gradually increases from the level 0. In the entire width t₁, although the level of the second control signal S₂ continuously increases, the level of the second control signal S₂ does not exceed the decision threshold D for the XOR operation circuit to determine the level 0 and the level 1. Therefore, the XOR operation circuit determines that the level input by the second input terminal b₂ is always less than the decision threshold D, that is, considers that the level of the second control signal S₂ received by the second input terminal b₂ is always the level 0. In this way, after the XOR operation circuit performs the XOR operation on the seventh control signal S₇ whose level is the level 0 and the second control signal S₂ whose level is the level 0, the level of the eighth control signal S₈ output at the output terminal b₃ of the XOR operation circuit is always the level 0. Further, after level inversion by the level inversion circuit, the level of the third control signal S₃ output at the output terminal of the level inversion circuit is always the level 1. Then, after the level of the first control signal S₁ changes from the level 1 to the level 0, the level 0 is inverted by the phase inverter, and the seventh control signal S₇ whose level is 1 is output at the output terminal of the phase inverter to the first input terminal b₁ of the XOR operation circuit. In addition, the level 0 passes through the RC delay circuit, and the capacitor C is discharged, so that the level of the second control signal S₂ output at the second terminal of the resistor R gradually decreases. In the entire width t₂, although the level of the second control signal S₂ continuously decreases, the level of the second control signal S₂ is always less than the decision threshold D for the XOR operation circuit to determine the level 0 and the level 1. Therefore, the XOR operation circuit determines that the level input by the second input terminal b₂ is always less than the decision threshold D, that is, considers that the level of the second control signal S₂ received by the second input terminal b₂ is always the level 0. In this way, after the XOR operation circuit performs the XOR operation on the seventh control signal S₇ whose level is the level 1 and the second control signal S₂ whose level is the level 0, the level of the eighth control signal S₈ output at the output terminal b₃ of the XOR operation circuit is always the level 1. Further, after level inversion by the level inversion circuit, the level of the third control signal S₃ output at the output terminal of the level inversion circuit is always the level 0. It can be learned that, when the width t₁ of the level 1 of the first control signal S₁ is small, the signal processing circuit shown in FIG. 22 can further output the third control signal S₃, to flexibly adjust, as the first control signal S₁ changes, duration of transmitting the laser signal by the transmitting circuit, where the width t₃ of the valid level 1 of the third control signal S₃ is equal to t₁.

It should be noted that the signal processing circuit 11 may alternatively change, by using the control circuit, a decision threshold and/or a time constant that are/is used by the XOR operation circuit to determine the level 0 and the level 1, to flexibly adjust the width of the valid level of the third control signal S₃. For a specific implementation operation, refer to the descriptions of the foregoing signal processing circuit 1. Details are not described in embodiments of this application again.

### Signal processing circuit 12

FIG. 27 is a schematic diagram of an example of a structure of still another signal processing circuit according to Embodiment 2 of this application. As shown in FIG. 27, in this example, the first subcircuit 310 includes a phase inverter and an XNOR operation circuit (namely, a device with an XNOR operation symbol "=" in FIG. 27), and the second subcircuit 320 includes a resistor R and a capacitor C. Both an input terminal of the phase inverter and a first terminal of the resistor R are configured to receive the first control signal S₁, an output terminal of the phase inverter is connected to a first input terminal b₁ of the XNOR operation circuit, a second terminal of the resistor R is connected to both a first terminal of the capacitor C and a second input terminal b₂ of the XNOR operation circuit, a second terminal of the capacitor C is grounded, and an output terminal b₃ of the XNOR operation circuit is configured to output the third control signal S₃. After the first control signal S₁ is inverted to a seventh control signal S₇ by the phase inverter, the seventh control signal S₇ is input to the first input terminal b₁ of the XNOR operation circuit. In addition, after the first control signal S₁ is delayed by an RC circuit, the second control signal S₂ is output at the second terminal of the resistor R, and then the second control signal S₂ is transmitted to the second input terminal b₂ of the XNOR operation circuit. After the XNOR operation circuit performs an XNOR operation on the seventh control signal S₇ received by the first input terminal b₁ and the second control signal S₂ received by the second input terminal b₂, the third control signal S₃ is output at the output terminal b₃ of the XNOR operation circuit.

It should be noted that, in the signal processing circuit 12, the valid level of the third control signal S₃ is the level 1, and the valid level of the first control signal S₁ may be the level 1 or the level 0. For a diagram of a time sequence of each node in the signal processing circuit 12, refer to the foregoing signal processing circuit 11. A difference lies in: In the signal processing circuit 11, the XOR operation is first performed on the seventh control signal S₇ and the second control signal S₂ to obtain the eighth control signal S₈ whose level is opposite to the level of the third control signal S₃, and then level inversion is performed to obtain the third control signal S₃. Instead, in the signal processing circuit 12, the XNOR operation circuit directly performs the XNOR operation on the seventh control signal S₇ input at the first input terminal b₁ and the second control signal S₂ input at the second input terminal b₂, to directly output the third control signal S₃ at the output terminal b₃ of the signal processing circuit 12. In addition, the signal processing circuit 12 may alternatively perform power driving on the third control signal S₃. A power drive circuit may be synchronously implemented in the XNOR operational circuit, or may be implemented by adding an additional power drive circuit. For the power drive circuit, refer to the descriptions of the foregoing signal processing circuit 2. Details are not described in embodiments of this application again. In addition, the signal processing circuit 12 may alternatively change, by using the control circuit, a decision threshold and/or a time constant that are/is used by the XNOR operational circuit to determine the level 0 and the level 1, to flexibly adjust the width of the valid level of the third control signal S₃. For a specific implementation operation, refer to the descriptions of the foregoing signal processing circuit 1. Details are not described in embodiments of this application again.

### Signal processing circuit 13

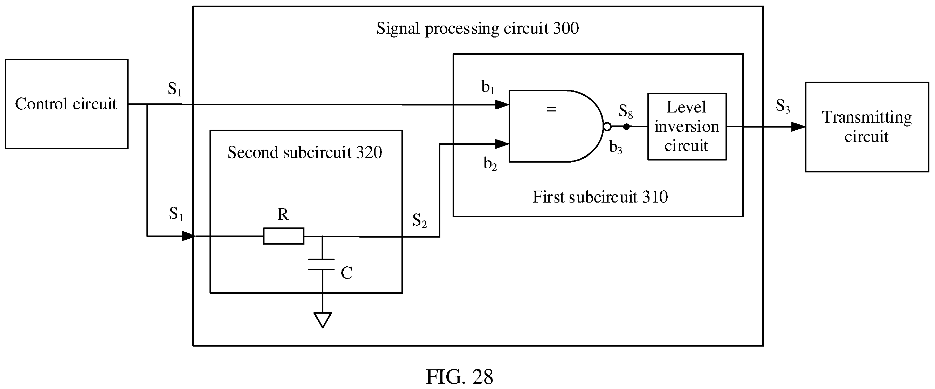

FIG. 28 is a schematic structural diagram of an example of still another signal processing circuit according to Embodiment 2 of this application. As shown in FIG. 28, in this example, the first subcircuit 310 includes an XNOR operation circuit (namely, a device with an XNOR operation symbol "=" in FIG. 28) and a level inversion circuit, and the second subcircuit 320 includes a resistor R and a capacitor C. Both a first input terminal b₁ of the XNOR operation circuit and a first terminal of the resistor R are configured to receive the first control signal S₁, a second terminal of the resistor R is connected to both a first terminal of the capacitor C and a second input terminal b₂ of the XNOR operation circuit, a second terminal of the capacitor C is grounded, an output terminal b₃ of the XNOR operation circuit is connected to an input terminal of a level inversion circuit, and an output terminal of the level inversion circuit is configured to output the third control signal S₃. The first control signal S₁ output by the control circuit is directly input to the first input terminal b₁ of the XNOR operation circuit. In addition, after the first control signal S₁ is delayed by an RC circuit, the second control signal S₂ is output at the second terminal of the resistor R, and then the second control signal S₂ is transmitted to the second input terminal b₂ of the XNOR operation circuit. After the XNOR operation circuit performs an XNOR operation on the first control signal S₁ received by the first input terminal b₁ and the second control signal S₂ received by the second input terminal b₂, an eighth control signal S₈ is output at the output terminal b₃ of the XNOR operation circuit. After level inversion by the level inversion circuit, the third control signal S₃ is output at the output terminal of the level inversion circuit.

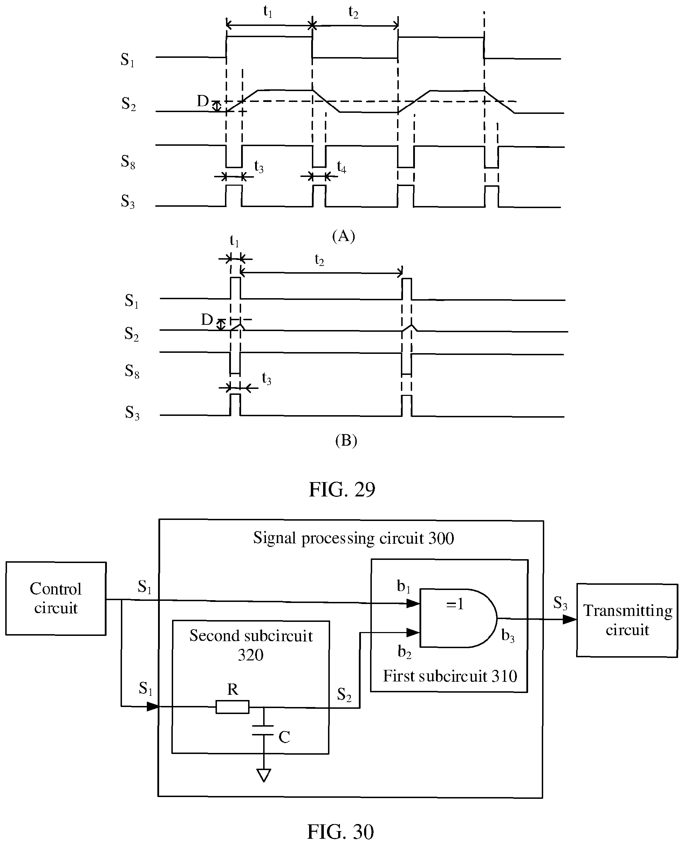

It should be noted that, in the signal processing circuit 13, the valid level of the third control signal S₃ is the level 1, and the valid level of the first control signal S₁ may be the level 1 or the level 0. For example, FIG. 29 is a schematic diagram of an example of a time sequence of each control signal in the foregoing signal processing circuit. In this example, t₁ is a width of one level 1 of the first control signal S₁, t₂ is a width of one level 0 of the first control signal S₁, D is a decision threshold for the XNOR operation circuit to determine whether an input level is the level 0 or the level 1, t₃ is a width of one valid level 1 of the third control signal S₃ in the width t₁ of one level 1 of the first control signal S₁, and t₄ is a width of one valid level 1 of the third control signal S₃ in the width t₂ of one level 0 of the first control signal S₁. (A) in FIG. 29 is a diagram of a time sequence in a case in which the width t₁ of one level 1 and the width t₂ of one level 0 of the first control signal S₁ are large, and (B) in FIG. 29 is a diagram of a time sequence in a case in which the width t₁ of one level 1 of the first control signal S₁ is small.

Refer to FIG. 28 and (A) in FIG. 29. After the level of the first control signal S₁ changes from the level 0 to the level 1, the level 1 is directly output to the first input terminal b₁ of the XNOR operation circuit. In addition, the level 1 passes through the RC delay circuit, and charges the capacitor C. In this way, a level of the second control signal S₂ output at the second terminal of the resistor R gradually increases from the level 0. In the first t₃ width of the width t₁, although the level of the second control signal S₂ increases, the level of the second control signal S₂ does not exceed the decision threshold D for the XNOR operation circuit to determine the level 0 and the level 1. Therefore, the XNOR operation circuit determines that the level of the second control signal S₂ is less than the decision threshold D, that is, considers that the level received by the second input terminal b₁ is the level 0. In this way, after the XNOR operation circuit performs the XNOR operation on the first control signal S₁ whose level is 1 and the second control signal S₂ whose level is 0, a level of the eighth control signal S₈ output at the output terminal b₃ of the XNOR operation circuit is the level 0. Further, after level inversion by the level inversion circuit, a level of the third control signal S₃ output at the output terminal of the level inversion circuit is the level 1. After the first t₃ width of the width t₁, the level of the second control signal S₂ increases to exceed the decision threshold D for the XNOR operation circuit to determine the level 0 and the level 1. The XNOR operation circuit determines that the level of the second control signal S₂ is not less than the decision threshold D, that is, considers that the level received by the second input terminal b₁ is the level 1. Therefore, after the XNOR operation circuit performs the XNOR operation on the first control signal S₁ whose level is the level 1 and the second control signal S₂ whose level is the level 1, the level of the eighth control signal S₈ output at the output terminal b₃ of the XNOR operation circuit is the level 1. Further, after level inversion by the level inversion circuit, the level of the third control signal S₃ output at the output terminal of the level inversion circuit is the level 0. Then, after the level of the first control signal S₁ changes from the level 1 to the level 0, the level 0 is directly output to the first input terminal b₁ of the XNOR operation circuit. In addition, the level 0 passes through the RC delay circuit, and the capacitor C is discharged, so that the level of the second control signal S₂ output at the second terminal of the resistor R gradually decreases from the level 1. In the first t₄ width of the width t₂, although the level of the second control signal S₂ decreases, the level of the second control signal S₂ is not less than the decision threshold D for the XNOR operation circuit to determine the level 0 and the level 1. Therefore, the XNOR operation circuit determines that the level of the second control signal S₂ is still greater than the decision threshold D, that is, considers that the level received by the second input terminal b₁ is still the level 1. In this way, after the XNOR operation circuit performs the XNOR operation on the first control signal S₁ whose level is 0 and the second control signal S₂ whose level is 1, the level of the eighth control signal S₈ output at the output terminal b₃ of the XNOR operation circuit is the level 0. Further, after level inversion by the level inversion circuit, the level of the third control signal S₃ output at the output terminal of the level inversion circuit is the level 1. After the first t₄ width of the width t₃, the level of the second control signal S₂ decreases to be less than the decision threshold D for the XNOR operation circuit to determine the level 0 and the level 1. The XNOR operation circuit determines that the level of the second control signal S₂ is less than the decision threshold D, that is, considers that the level received by the second input terminal b₁ changes to the level 0. Therefore, after the XNOR operation circuit performs the XNOR operation on the first control signal S₁ whose level is the level 0 and the second control signal S₂ whose level is the level 0, the level of the eighth control signal S₈ output at the output terminal b₃ of the XNOR operation circuit is the level 1. Further, after level inversion by the level inversion circuit, the level of the third control signal S₃ output at the output terminal of the level inversion circuit is the level 0. It can be learned that, when both the width t₁ of one level 1 of the first control signal S₁ and the width t₂ of one level 0 of the first control signal S₁ are large, the signal processing circuit shown in FIG. 28 can not only generate a valid level 1 with the width t₃ in the width t₁ of one level 1 of the first control signal S₁, but also generate a valid level 1 with the width of t₄ in the width t₂ of one level 0 of the first control signal S₁. That is, the third control signal S₃ having two narrow widths are generated in a width of one level 1 and one level 0 of the first control signal.

Refer to FIG. 28 and (B) in FIG. 29. After the level of the first control signal S₁ changes from the level 0 to the level 1, the level 1 is directly input to the first input terminal b₁ of the XNOR operation circuit. In addition, the level 1 passes through the RC delay circuit, and charges the capacitor C. In this way, a level of the second control signal S₂ output at the second terminal of the resistor R gradually increases from the level 0. In the entire width t₁, although the level of the second control signal S₂ continuously increases, the level of the second control signal S₂ does not exceed the decision threshold D for the XNOR operation circuit to determine the level 0 and the level 1. Therefore, the XNOR operation circuit determines that the level input by the second input terminal b₂ is always less than the decision threshold D, that is, considers that the level of the second control signal S₂ received by the second input terminal b₂ is always the level 0. In this way, after the XNOR operation circuit performs the XNOR operation on the first control signal S₁ whose level is the level 1 and the second control signal S₂ whose level is the level 0, the level of the eighth control signal S₈ output at the output terminal b₃ of the XNOR operation circuit is always the level 0. Further, after level inversion by the level inversion circuit, the level of the third control signal S₃ output at the output terminal of the level inversion circuit is always the level 1. Then, after the level of the first control signal S₁ changes from the level 1 to the level 0, the level 0 is directly input to the first input terminal b₁ of the XNOR operation circuit. In addition, the level 0 passes through the RC delay circuit, and the capacitor C is discharged, so that the level of the second control signal S₂ output at the second terminal of the resistor R gradually decreases. In the entire width t₂, although the level of the second control signal S₂ continuously decreases, the level of the second control signal S₂ is less than the decision threshold D for the XNOR operation circuit to determine the level 0 and the level 1. Therefore, the XNOR operation circuit determines that the level input by the second input terminal b₂ is always less than the decision threshold D, that is, considers that the level of the second control signal S₂ received by the second input terminal b₂ is always the level 0. In this way, after the XNOR operation circuit performs the XNOR operation on the first control signal S₁ whose level is the level 0 and the second control signal S₂ whose level is the level 0, the level of the eighth control signal S₈ output at the output terminal b₃ of the XNOR operation circuit is always the level 1. Further, after level inversion by the level inversion circuit, the level of the third control signal S₃ output at the output terminal of the level inversion circuit is always the level 0. It can be learned that, when the width t₁ of the level 1 of the first control signal S₁ is small, the signal processing circuit shown in FIG. 28 can further output the third control signal S₃, to flexibly adjust, as the first control signal S₁ changes, duration of transmitting the laser signal by the transmitting circuit, where the width t₃ of the valid level 1 of the third control signal S₃ is equal to t₁.

It should be noted that the signal processing circuit 13 may alternatively change, by using the control circuit, a decision threshold and/or a time constant that are/is used by the XNOR operation circuit to determine the level 0 and the level 1, to flexibly adjust the width of the valid level of the third control signal S₃. For a specific implementation operation, refer to the descriptions of the foregoing signal processing circuit 1. Details are not described in embodiments of this application again.

### Signal processing circuit 14

FIG. 30 is a schematic diagram of an example of a structure of still another signal processing circuit according to Embodiment 2 of this application. As shown in FIG. 30, in this example, the first subcircuit 310 includes an XOR operation circuit (namely, a device with an XOR operation symbol "=1" in FIG. 30), and the second subcircuit 320 includes a resistor R and a capacitor C. Both a first input terminal b₁ of the XOR operation circuit and a first terminal of the resistor R are configured to receive the first control signal S₁, a second terminal of the resistor R is connected to both a first terminal of the capacitor C and a second input terminal b₂ of the XOR operation circuit, a second terminal of the capacitor C is grounded, and an output terminal b₃ of the XOR operation circuit is configured to output the third control signal S₃. The first control signal S₁ output by the control circuit is directly input to the first input terminal b₁ of the XOR operation circuit. In addition, after the first control signal S₁ is delayed by an RC circuit, the second control signal S₂ is output at the second terminal of the resistor R, and then the second control signal S₂ is transmitted to the second input terminal b₂ of the XOR operation circuit. After the XOR operation circuit performs an XOR operation on the first control signal S₁ received by the first input terminal b₁ and the second control signal S₂ received by the second input terminal b₂, the third control signal S₃ is output at the output terminal b₃ of the XOR operation circuit.

It should be noted that, in the signal processing circuit 14, the valid level of the third control signal S₃ is the level 1, and the valid level of the first control signal S₁ may be the level 1 or the level 0. For a diagram of a time sequence of each node in the signal processing circuit 14, refer to the foregoing signal processing circuit 13. A difference lies in: In the signal processing circuit 13, the XNOR operation is first performed on the first control signal S₁ and the second control signal S₂ to obtain the eighth control signal S₈ whose level is opposite to the level of the third control signal S₃, and then level inversion is performed to obtain the third control signal S₃. Instead, in the signal processing circuit 14, the XOR operation circuit directly performs the XOR operation on the first control signal S₁ input at the first input terminal b₁ and the second control signal S₂ input at the second input terminal b₂, to directly output the third control signal S₃ at the output terminal b₃ of the signal processing circuit 14. In addition, the signal processing circuit 14 may alternatively perform power driving on the third control signal S₃. A power drive circuit may be synchronously implemented in the XOR operational circuit, or may be implemented by adding an additional power drive circuit. For the power drive circuit, refer to the descriptions of the foregoing signal processing circuit 2. Details are not described in embodiments of this application again. In addition, the signal processing circuit 14 may alternatively change, by using the control circuit, a decision threshold and/or a time constant that are/is used by the XOR operational circuit to determine the level 0 and the level 1, to flexibly adjust the width of the valid level of the third control signal S₃. For a specific implementation operation, refer to the descriptions of the foregoing signal processing circuit 1. Details are not described in embodiments of this application again.

Further, for example, in addition to the signal processing circuits 5, 6, and 11 to 14 that are compatible with two scenarios in which the valid level of the first control signal S₁ is the level 1 and the level 0, the signal processing circuits 1 to 4 and 7 to 10 are all applicable to a scenario of a valid level. Therefore, to enable the signal processing circuit to be further compatible with scenarios of different valid levels, the signal processing circuit 300 may alternatively include a plurality of first subcircuits 310 and a plurality of second subcircuits 320. The plurality of first subcircuits 310 and the plurality of second subcircuits 320 may be in a one-to-one correspondence, or may be in a one-to-many correspondence, and each group of corresponding first subcircuit 310 and second subcircuit 320 may be one group of the first subcircuit 310 and the second subcircuit 320 in the foregoing signal processing circuits 1 to 14. For example, it is assumed that there are M (where M is a positive integer greater than or equal to 2) groups of corresponding first subcircuits 310 and second subcircuits 320. In a possible implementation, in the M groups of corresponding first subcircuits 310 and second subcircuits 320, there are T (where T is a positive integer less than M) groups of corresponding first subcircuits 310 and second subcircuits 320 that have the structures of the first subcircuit 310 and the second subcircuit 320 in the signal processing circuit 1. M-T groups of first subcircuits 310 and second subcircuits 320 other than the T groups of corresponding first subcircuits 310 and second subcircuits 320 have the structures of the first subcircuit 310 and the second subcircuit 320 in the signal processing circuit 3. In this way, the T groups in the M groups are applicable to the scenario in which the valid level of the first control signal is 1, and the other M-T groups in the M groups are applicable to the scenario in which the valid level of the first control signal is 0, so that the control circuit can switch the second subcircuit, to enable the signal processing circuit to be compatible with the two scenarios in which the valid level of the first control signal is 1 and the valid level of the first control signal is 0. Certainly, the M groups of corresponding first subcircuits 310 and second subcircuits 320 may alternatively be the first subcircuits 310 and the second subcircuits 320 that correspond to the same valid level of the first control signal, or the same first subcircuit 310 and the same second subcircuit 320, so that the control circuit can perform management in a centralized manner by using a unified structure, to simplify complexity of the entire circuit as much as possible. This is not specifically limited in embodiments of this application.

In addition, the foregoing provides only examples of several possible hardware implementations. Any solution in which the third control signal whose valid level is the same as the valid level of the first control signal in width can be output when the width of the valid level of the first control signal is less than the threshold width, and the third control signal whose valid level is smaller than the valid level of the first control signal in width can be output when the width of the valid level of the first control signal is not less than the threshold width falls within the protection scope of embodiments of this application. In addition, the signal processing solutions provided in embodiments of this application may be further extended to any circuit information system in which a width of a control signal needs to be limited. For example, in some scenarios, after obtaining a third control signal whose valid level has a small width according to the signal processing solutions in embodiments of this application, a signal processing circuit may further generate another control signal that has a specific rule with the third control signal and send the control signal to a controlled circuit. Alternatively, in some other scenarios, a signal processing circuit may be further used in another circuit system, for example, a motor. It should be understood that any technical solution in which the signal processing solutions provided in embodiments of this application are used to adjust a width of a valid level falls within the protection scope of embodiments of this application. Details are not listed one by one in embodiments of this application.

According to the signal processing circuit provided in embodiments of this application, an embodiment of this application further provides a transmitting system. The transmitting system includes the transmitting circuit and the signal processing circuit described in the foregoing content. An output terminal of the signal processing circuit is connected to the transmitting circuit. The transmitting circuit is configured to intermittently send a laser signal based on a third control signal output by the signal processing circuit, to protect safety of the transmitting circuit and safety of human eyes.

According to the signal processing circuit provided in embodiments of this application, an embodiment of this application further provides a lidar. The lidar includes the control circuit and the transmitting system described in the foregoing content. The control circuit may be configured to input a first control signal to the transmitting system. In some embodiments, the control circuit may further flexibly adjust a width of a valid level of the third control signal by adjusting the second subcircuit in the signal processing circuit of the transmitting system based on the foregoing content.

According to the signal processing circuit provided in embodiments of this application, an embodiment of this application further provides a terminal device. The terminal device includes the lidar described in the foregoing content.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A signal processing circuit, comprising a first subcircuit, wherein
the first subcircuit comprises a first input terminal, a second input terminal, and an output terminal;
the first input terminal of the first subcircuit is configured to receive a first control signal;
the second input terminal of the first subcircuit is configured to receive a second control signal; and
the first subcircuit is configured to: perform a logical operation on the first control signal and the second control signal, and output a third control signal at the output terminal of the first subcircuit, wherein a width of a valid level of the third control signal is not greater than a width of a valid level of the first control signal.

2. The signal processing circuit according to claim 1, further comprising a second subcircuit, wherein
the second subcircuit comprises an input terminal and an output terminal;
the input terminal of the second subcircuit is configured to receive the first control signal;
the output terminal of the second subcircuit is connected to the second input terminal of the first subcircuit; and
the second subcircuit is configured to: perform phase adjustment on the first control signal, and output the second control signal at the output terminal of the second subcircuit.

3. The signal processing circuit according to claim 2, wherein
the second subcircuit comprises a resistor, a capacitor, and a phase inverter, a first terminal of the resistor is the input terminal of the second subcircuit, a second terminal of the resistor is connected to both a first terminal of the capacitor and an input terminal of the phase inverter, a second terminal of the capacitor is grounded, and an output terminal of the phase inverter is the output terminal of the second subcircuit.

4. The signal processing circuit according to claim 3, wherein the valid level of the first control signal is a high level; and
the first subcircuit comprises an AND operation circuit, a first input terminal of the AND operation circuit is the first input terminal of the first subcircuit, a second input terminal of the AND operation circuit is the second input terminal of the first subcircuit, and an output terminal of the AND operation circuit is the output terminal of the first subcircuit; or
the first subcircuit comprises a NAND operation circuit and a level inversion circuit, a first input terminal of the NAND operation circuit is the first input terminal of the first subcircuit, a second input terminal of the NAND operation circuit is the second input terminal of the first subcircuit, an output terminal of the NAND operation circuit is connected to an input terminal of the level inversion circuit, and an output terminal of the level inversion circuit is the output terminal of the first subcircuit.

5. The signal processing circuit according to claim 3, wherein the valid level of the first control signal is a low level; and
the first subcircuit comprises a NOR operation circuit, a first input terminal of the NOR operation circuit is the first input terminal of the first subcircuit, a second input terminal of the NOR operation circuit is the second input terminal of the first subcircuit, and an output terminal of the NOR operation circuit is the output terminal of the first subcircuit; or
the first subcircuit comprises an OR operation circuit and a level inversion circuit, a first input terminal of the OR operation circuit is the first input terminal of the first subcircuit, a second input terminal of the OR operation circuit is the second input terminal of the first subcircuit, an output terminal of the OR operation circuit is connected to an input terminal of the level inversion circuit, and an output terminal of the level inversion circuit is the output terminal of the first subcircuit.

6. The signal processing circuit according to claim 3, wherein the valid level of the first control signal is a high level or a low level; and
the first subcircuit comprises an XOR operation circuit and a level inversion circuit, a first input terminal of the XOR operation circuit is the first input terminal of the first subcircuit, a second input terminal of the XOR operation circuit is the second input terminal of the first subcircuit, an output terminal of the XOR operation circuit is connected to an input terminal of the level inversion circuit, and an output terminal of the level inversion circuit is the output terminal of the first subcircuit; or
the first subcircuit comprises an XNOR operation circuit, a first input terminal of the XNOR operation circuit is the first input terminal of the first subcircuit, a second input terminal of the XNOR operation circuit is the second input terminal of the first subcircuit, and an output terminal of the XNOR operation circuit is the output terminal of the first subcircuit.

7. The signal processing circuit according to claim 2, wherein
the second subcircuit comprises a resistor and a capacitor, a first terminal of the resistor is the input terminal of the second subcircuit, a second terminal of the resistor is used as the output terminal of the second subcircuit after being connected to a first terminal of the capacitor, and a second terminal of the capacitor is grounded.

8. The signal processing circuit according to claim 7, wherein the valid level of the first control signal is a low level; and
the first subcircuit comprises a phase inverter and an AND operation circuit, an input terminal of the phase inverter is the first input terminal of the first subcircuit, an output terminal of the phase inverter is connected to a first input terminal of the AND operation circuit, a second input terminal of the AND operation circuit is the second input terminal of the first subcircuit, and an output terminal of the AND operation circuit is the output terminal of the first subcircuit; or
the first subcircuit comprises a phase inverter, a NAND operation circuit, and a level inversion circuit, an input terminal of the phase inverter is the first input terminal of the first subcircuit, an output terminal of the phase inverter is connected to a first input terminal of the NAND operation circuit, a second input terminal of the NAND operation circuit is the second input terminal of the first subcircuit, an output terminal of the NAND operation circuit is connected to an input terminal of the level inversion circuit, and an output terminal of the level inversion circuit is the output terminal of the first subcircuit.

9. The signal processing circuit according to claim 7, wherein the valid level of the first control signal is a high level; and
the first subcircuit comprises a phase inverter and a NOR operation circuit, an input terminal of the phase inverter is the first input terminal of the first subcircuit, an output terminal of the phase inverter is connected to a first input terminal of the NOR operation circuit, a second input terminal of the NOR operation circuit is the second input terminal of the first subcircuit, and an output terminal of the NOR operation circuit is the output terminal of the first subcircuit; or
the first subcircuit comprises a phase inverter, an OR operation circuit, and a level inversion circuit, an input terminal of the phase inverter is the first input terminal of the first subcircuit, an output terminal of the phase inverter is connected to a first input terminal of the OR operation circuit, a second input terminal of the OR operation circuit is the second input terminal of the first subcircuit, an output terminal of the OR operation circuit is connected to an input terminal of the level inversion circuit, and an output terminal of the level inversion circuit is the output terminal of the first subcircuit.

10. The signal processing circuit according to claim 7, wherein the valid level of the first control signal is a high level or a low level; and
the first subcircuit comprises a phase inverter, an XOR operation circuit, and a level inversion circuit, an input terminal of the phase inverter is the first input terminal of the first subcircuit, an output terminal of the phase inverter is connected to a first input terminal of the XOR operation circuit, a second input terminal of the XOR operation circuit is the second input terminal of the first subcircuit, an output terminal of the XOR operation circuit is connected to an input terminal of the level inversion circuit, and an output terminal of the level inversion circuit is the output terminal of the first subcircuit; or
the first subcircuit comprises a phase inverter and an XNOR operation circuit, an input terminal of the phase inverter is the first input terminal of the first subcircuit, an output terminal of the phase inverter is connected to a first input terminal of the XNOR operation circuit, a second input terminal of the XNOR operation circuit is the second input terminal of the first subcircuit, and an output terminal of the XNOR operation circuit is the output terminal of the first subcircuit; or
the first subcircuit comprises an XNOR operation circuit and a level inversion circuit, a first input terminal of the XNOR operation circuit is the first input terminal of the first subcircuit, a second input terminal of the XNOR operation circuit is the second input terminal of the first subcircuit, an output terminal of the XNOR operation circuit is connected to an input terminal of the level inversion circuit, and an output terminal of the level inversion circuit is the output terminal of the first subcircuit; or
the first subcircuit comprises an XOR operation circuit, a first input terminal of the XOR operation circuit is the first input terminal of the first subcircuit, a second input terminal of the XOR operation circuit is the second input terminal of the first subcircuit, and an output terminal of the XOR operation circuit is the output terminal of the first subcircuit.

11. The signal processing circuit according to any one of claims 4, 5, 6, 8, 9, and 10, wherein the level inversion circuit comprises a P-channel metal-oxide-semiconductor field-effect transistor PMOS and an N-channel metal-oxide-semiconductor field-effect transistor NMOS, a gate of the PMOS is used as the input terminal of the level inversion circuit after being connected to a gate of the NMOS, a drain of the PMOS is used as the output terminal of the level inverter after being connected to a drain of the NMOS, a source of the PMOS is connected to a drive power supply, and a source of the NMOS is grounded.

12. The signal processing circuit according to any one of claims 2 to 11, wherein the signal processing circuit comprises N second subcircuits with different phase adjustment amplitudes and N switches, the N switches correspond to the N second subcircuits, and N is a positive integer greater than or equal to 2;
a target second subcircuit in the N second subcircuits is configured to turn on a switch in the target subcircuit based on a first control message from a control circuit, to output the second control signal; and
N-1 second subcircuits other than the target second subcircuit in the N second subcircuits are configured to turn off switches in the N-1 second subcircuits based on a second control message from the control circuit.

13. The signal processing circuit according to claim 12, wherein each of the N second subcircuits comprises a resistor-capacitor circuit; and
time constants of resistor-capacitor circuits of the N second subcircuits are different from each other.

14. The signal processing circuit according to any one of claims 2 to 13, wherein when the second subcircuit comprises the phase inverter,
the phase inverter is configured to increase or decrease a decision threshold based on a third control message from the control circuit.

15. The signal processing circuit according to claim 1, wherein the first control signal and the second control signal are from two output terminals of a same control circuit.

16. The signal processing circuit according to any one of claims 1 to 15, wherein the third control signal is used to control a transmitting circuit to send a laser signal.

17. The signal processing circuit according to any one of claims 1 to 16, wherein
when the width of the valid level of the first control signal is not greater than a threshold width, the width of the valid level of the third control signal is the same as the width of the valid level of the first control signal; or
when the width of the valid level of the first control signal is greater than a threshold width, the width of the valid level of the third control signal is the threshold width.

18. The signal processing circuit according to claim 17, wherein within a width of one valid level of the first control signal,
a width of a first level of the second control signal is a smallest width in the width of the valid level of the first control signal and the threshold width, a level of the third control signal is a valid level within an overlapping level width of the first level of the second control signal and the valid level of the first control signal, and the level of the third control signal is an invalid level within a width other than the overlapping level width.

19. A transmitting system, comprising a transmitting circuit and the signal processing circuit according to any one of claims 1 to 18, wherein an output terminal of the signal processing circuit is connected to the transmitting circuit; and
the transmitting circuit is configured to send a signal based on a third control signal output by the signal processing circuit.

20. A lidar, comprising a control circuit and the transmitting system according to claim 19, wherein
the control circuit is configured to input a first control signal to the transmitting system.

21. A terminal device, comprising the lidar according to claim 20.
